# EUROPEAN PATENT APPLICATION

(11) **EP 4 672 310 A1**
(43) Date of publication of application: **31.12.2025**
(21) Application number: 25185022.8
(22) Date of filing: 24.06.2025
(51) Int. Cl.: H01L 21/768, H01L 23/485, H01L 23/532, H10D 30/00

(54) **SILICON TRENCH FILL BETWEEN SOURCE AND DRAIN FOR WIDER CONTACTS**

(30) Priority: 28.06.2024 US 202418759216
(71) Applicant: INTEL Corporation, Santa Clara, CA 95054 (US)
(72) Inventor: CHU, Tao, Portland, OR 97229 (US); XU, Guowei, Portland, OR 97229 (US); CHAO, Robin, Portland, OR 97209 (US); ZHANG, Feng, Portland, OR 97229 (US); HUNG, Ting-Hsiang, Santa Clara, CA 95051 (US); LIN, Chia-Ching, Portland, OR 97229 (US); ZHANG, Yang, Rio Rancho, NM 87124 (US); ZHANG, Kan, Hillsboro, OR 97123 (US); YEUNG, Chun Wing, Portland, OR 97229 (US); JANG, Minwoo, Portland, OR 97229 (US); LUO, Yanbin, Portland, OR 97229 (US); PACKAN, Paul A., Hillsboro, OR 97124 (US); LIN, Chung-Hsun, Portland, OR 97229 (US); MURTHY, Anand, Portland, OR 97229 (US)
(74) Representative: 2SPL Patentanwälte PartG mbB

(57) **Abstract**

Integrated circuit (IC) devices having contacts to source and drain bodies in narrow trenches. An IC device includes first and second source or drain bodies in first and second transistors, first and second contact structures on the first and second source or drain bodies, and a dielectric between the first and second source or drain bodies and between the first and second metallization structures, and the dielectric may consist of substantially pure silicon, for example, amorphous silicon. The dielectric includes silicon and is devoid of oxygen and nitrogen. The contact structures may be formed using an etch of the silicon dielectric in the contact trenches that is selective to other dielectrics.

## Description

### BACKGROUND

As industry pressures continually drive down device dimensions, the fabrication of high-performing and dependable integrated circuit (IC) devices may require innovative solutions, for example, to both thoroughly contact and reliably isolate transistor terminals. Narrowing contact trenches reduce critical dimensions (CDs), and efforts to increase contact areas (for example, with aggressive etches) may degrade thinning spacer isolations between source/drain and gate metallizations.

New techniques and materials are needed to improve performance and reliability.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A and 1B illustrate cross-sectional profile views of an integrated circuit (IC) device having multiple adjacent dielectrics with etch selectivities between transistor structures, in accordance with some embodiments;
FIGS. 2A, 2B, and 2C illustrate plan views of an IC device having dielectric stacks between adjacent contact structures, including a dielectric over trenches, transistor structures, and trench isolations, in accordance with some embodiments;
FIGS. 3A and 3B illustrate cross-sectional profile views of an IC device having a cap dielectric over gate contacts and enhanced contact structures on source and drain bodies and through the cap dielectric, in accordance with some embodiments;
FIG. 4 is a flow chart of methods for forming enhanced contact structures in and through dielectric stacks with excellent etch selectivities, in accordance with some embodiments;
FIGS. 5A, 5B, 5C, 5D, 5E, 5F, 5G, 5H, 5I, and 5J illustrate cross-sectional profile views of dielectric stacks having dielectrics with superior etch selectivities between transistor structures and enhanced contact structures, at various stages of manufacture, in accordance with some embodiments;
FIG. 6 illustrates a diagram of an example data server machine employing an IC device having enhanced contacts on source and drain bodies, in accordance with some embodiments; and
FIG. 7 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Materials, structures, and techniques are disclosed to provide enhanced source and drain contacts in integrated circuit (IC) devices having non-planar transistors.

As device dimensions (e.g., trench widths) shrink, sufficient contacts may become increasingly difficult to form. Transistor dielectrics, for example, in and adjacent source and drain contact trenches, are conventionally oxide- and/or nitride-based. Even high-aspect ratio dry etching of oxide dielectrics results in overly trapezoidal etches and reduced contact critical dimensions (CDs) in narrowed trenches. However, the use of amorphous silicon (a-Si) provides superior etch selectivities to adjacent insulators and other structures. A more selective contact etch of trench fill enables wider transistor contacts and so lower external resistances (Rₑₓₜ) and improved device performance. Increased etch selectivities to spacer dielectrics improves contact yields and reliability, for example, by reducing spacer failures due to overly aggressive (or insufficiently selective) etching. More selective contact etching provides wider process windows for narrow contact trenches and less damage to source and drain epi, e.g., relative to a conventional reactive-ion etch (RIE).

The present disclosure describes the deployment of non-oxide and non-nitride dielectrics, such as amorphous silicon, as trench fill over and between source and drain epitaxial bodies. Silicon insulation may be paired with other masking or dielectric layers during processing (e.g., polysilicon gate removal) to provide necessary and superior etch selectivities. Enhanced contacts (for example, with increased contact CDs) may be fabricated to improve IC device performance and reliability.

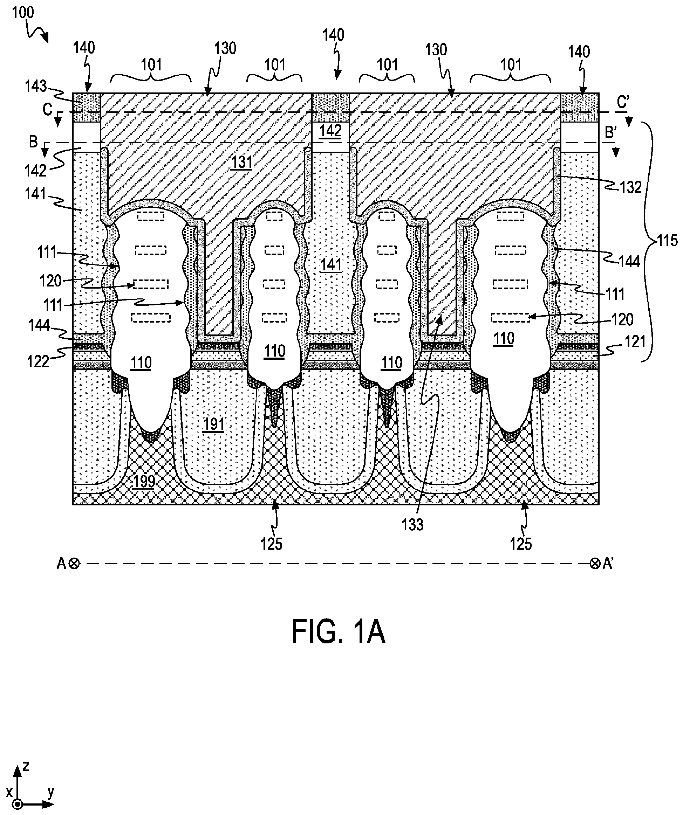

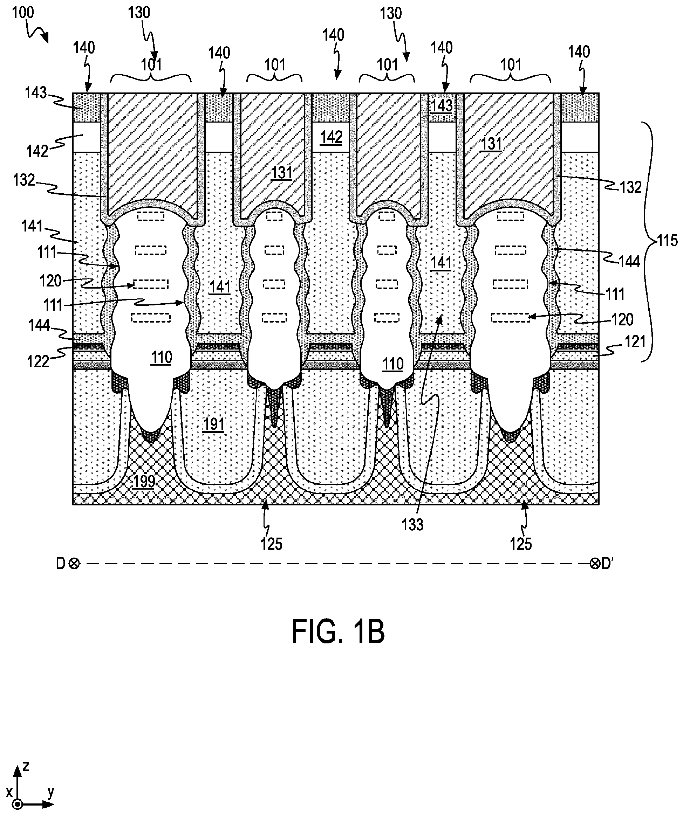

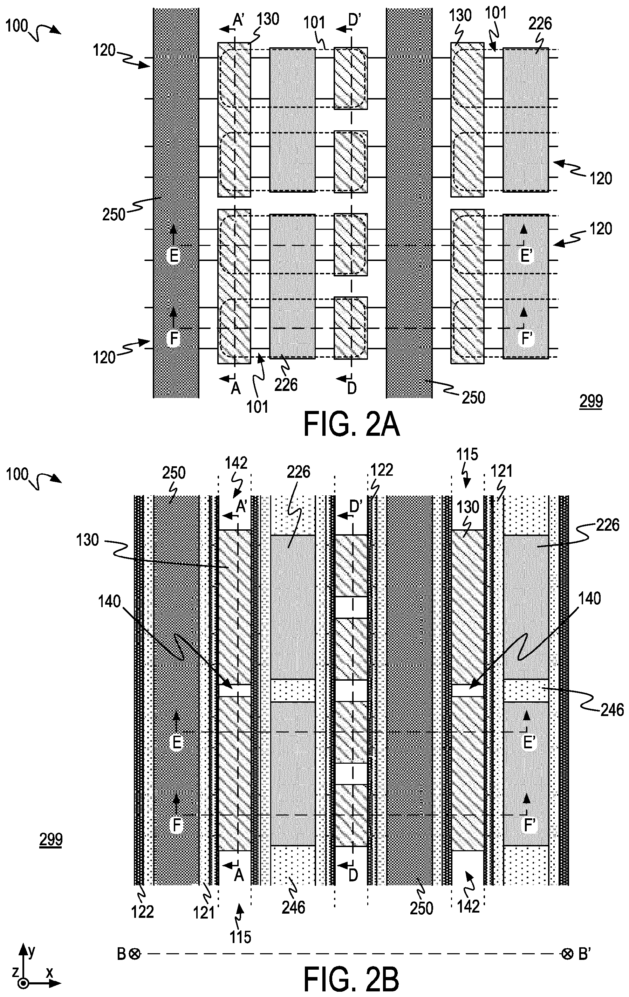

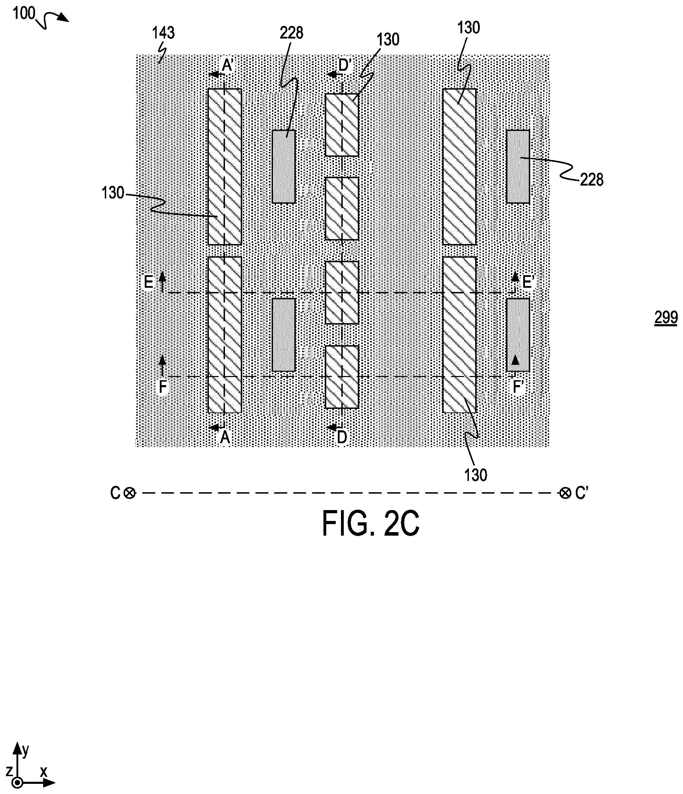

FIGS. 1A and 1B illustrate cross-sectional profile views of an IC device 100 having multiple adjacent dielectrics 141, 142, 143 with etch selectivities between transistor structures 101, in accordance with some embodiments. For example, multiple dielectrics (such as dielectrics 142, 143) adjacent to dielectric 141 may be oxides or nitrides (or oxynitrides), etc., and dielectric 141 may be completely devoid of oxygen and nitrogen, which may provide etch selectivities with those adjacent dielectrics (such as any of dielectrics 142, 143 having oxygen and/or nitrogen). In many embodiments, dielectric 141 is pure silicon, e.g., amorphous silicon, which may provide etch selectivities with adjacent oxides, nitrides, oxynitrides, etc. In some embodiments, a durable dielectric 142 may be deployed over a low-permittivity ("low-K") dielectric 141 and, due to an etch selectivity between dielectrics 141, 142, protect dielectric 141 during certain processing operations on device 100. FIG. 1A shows a cross-sectional profile view A-A' of dielectric stacks 140 between adjacent source and drain material bodies 110 in transistor structures 101 and over a substrate 199 and metallization structures 130 over and between bodies 110. The orientation and depth of plan views B-B' of FIG. 2B and C-C' of FIG. 2C are indicated in FIG. 1A (e.g., through dielectrics 142, 143, respectively). FIG. 1B illustrates a cross-sectional profile view D-D' of dielectric stacks 140 between adjacent metallization structures 130 and between adjacent source and drain material bodies 110. The orientation of profile views A-A' of FIG. 1A and D-D' of FIG. 1B are indicated in FIGS. 2A-2C.

FIG. 1A shows a cross-sectional profile of IC device 100 in a y-z plane. Device 100 includes multiple transistor structures 101 having source and drain material bodies 110 in a trench 115 filled with dielectric 141. Each body 110 shown in FIG. 1A is in a distinct n- or p-type transistor structure 101. Complementary pairs of n- and p-type structures 101 are coupled (e.g., electrically) by shared structures 130 on the respective source or drain bodies 110 of each structure 101. For example, in the embodiment of FIG. 1A, the inner transistor structures 101 are p-type structures 101, and the outer structures 101 are n-type structures 101. Structures 101 may be metal-oxide-semiconductor (MOS) structures 101. Pairs of n- and p-type transistor structures 101 may be in complementary devices, for example, complementary MOS (CMOS) devices. Other organizations (e.g., of all n- or all p-type structures 101) may be employed.

The cross-sectional profile view of FIG. 1A is through bodies 110 with channel regions 120 (shown with a dashed outline, though not actually in the viewing plane, e.g., for reference or illustrative purposes) in front of or behind the visible y-z plane. Transistor structures 101 each include pairs of bodies 110 coupled by channel regions 120. Source or drain material bodies 110 may be in contact with channel regions 120 in the positive and/or negative x-directions, in front of or behind the visible y-z plane. For example, each structure 101 may include a first source or drain body 110 in trench 115 and the y-z plane of FIG. 1A coupled by channel regions 120 to a second source or drain body 110 (not shown) in a second trench 115 (not shown) in the positive or negative x-direction. Each body 110 is coupled by one or more regions 120 in one or more pairs with one or more other bodies 110 in the positive and/or negative x-directions. For example, each visible body 110 may be paired by a channel region 120 to another body 110 (not shown in the viewing plane) in the positive x-direction, to another body 110 (not shown in the viewing plane) in the negative x-direction, or to bodies 110 in both the positive and negative x-directions.

Device 100 includes dielectric 141 over substrate 199 in a dielectric stack 140. Dielectric 141 is between adjacent bodies 110 and between adjacent metallization structures 130. Dielectric 142 is in stack 140, on and over dielectric 141 and between adjacent metallization structures 130. Dielectric 143 is in stack 140, over dielectrics 141, 142, on dielectric 142, and between adjacent metallization structures 130. Stacks 140 are to either side of structures 130, and each of the metallization structures 130 is between a pair of stacks 140. Dielectrics 141, 142, 143 are each distinct dielectric materials (e.g., a layer of dielectric 142 separates different dielectrics 141, 143, and is not just an etch-stop layer between two layers of dielectric 141 or 143 having a same composition).

Dielectrics 141, 142 are in trench 115, between and in contact with sidewalls (not shown) of trench 115. Dielectric 143 is over dielectrics 141, 142, but extends over and beyond sidewalls (not shown) of trench 115, e.g., in both the positive and negative x-directions. Trench 115 may be between adjacent gate structures over channel regions 120 coupled to source or drain bodies 110. Trenches 115 may extend in the y-directions, between parallel sidewalls of adjacent gate structures, the sidewalls also extending in the y-directions.

Dielectric 141 provides isolation (e.g., electrical isolation) between adjacent structures in device 100, e.g., between adjacent source and drain bodies 110, between adjacent metallization structures 130, etc. Advantageously, dielectric 141 is a low-K dielectric. In many embodiments, dielectric 141 has a lower relative permittivity or dielectric constant than dielectrics 142, 143. Advantageously, dielectric 141 has an etch selectivity with adjacent structures and materials, such as dielectrics 142, 143. For example, materials (such as dielectrics 142, 143) adjacent to dielectric 141 may be or include oxides or nitrides (or oxynitrides), etc., and dielectric 141 may be completely devoid of oxygen and nitrogen, which may provide etch selectivities with those adjacent materials (such as any of dielectrics 142, 143 having oxygen and/or nitrogen). In many embodiments, dielectric 141 does not include detectable proportions of oxygen or nitrogen.

In many embodiments, dielectric 141 is intrinsic or pure silicon, which indicates that dielectric 141 includes silicon and less than 1% of other elements. Dielectric 141 of substantially pure silicon may include some other materials, but with a composition of at least 95% silicon. Dielectric 141 is not crystalline, neither monocrystalline or polycrystalline. (Here, polycrystalline silicon refers to silicon consisting solely of crystalline silicon grains, separated by grain boundaries.) In many embodiments, dielectric 141 is amorphous silicon, which may be sufficiently insulative (e.g., not electrically conductive) and provide etch selectivities with adjacent oxides, nitrides, oxynitrides, etc. Dielectric 141 is amorphous or nanocrystalline, having a continuous random network (with or without many dangling or floating bonds) and lacking the long-range order present in crystalline materials. Dielectric 141 may advantageously be amorphous, e.g., to minimize conductivity. Dielectric 141 may be nanocrystalline, having small grains or crystals within a mostly amorphous bulk, for example, due to conditions (e.g., high temperatures, high-energy plasmas, etc.) during processing.

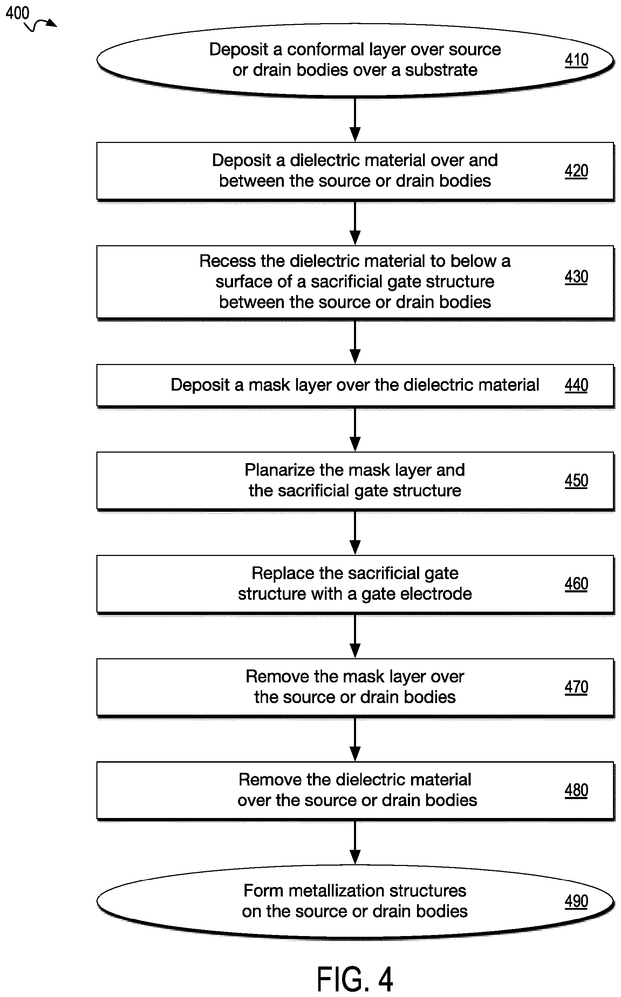

In many embodiments, dielectric 142 has an etch selectivity with adjacent structures, e.g., dielectrics 141, 143. An etch selectivity of dielectric 142 may provide protection (e.g., to dielectric 141), for example, during an etch process of a structure with a composition similar to that being etched. Similarly, dielectric 142 (and an etch selectivity of dielectric 142) may offer processing flexibility, for example, by enabling a selective (e.g., self-aligned) etch of a structure or material with a portion to be removed, as will be described later, e.g., at FIG. 4 and methods 400. Dielectric 142 may have any suitable thickness. In many embodiments, dielectric 142 has a thickness less than a thickness of dielectric 143 above dielectric 142. In some embodiments, layer 144 has a thickness of 10 nm or less. In some embodiments, dielectric 142 may have a minimal thickness, e.g., due to a planarization operation over substrate 199 or of an etch not completely selective to dielectric 142. In some embodiments, dielectric 142 is not present, e.g., completely removed over dielectric 141. In many embodiments, dielectric 142 includes oxygen. In some such embodiments, dielectric 142 includes aluminum (e.g., in an oxide of aluminum, AlₓO_{y}, such as Al₂O₃). Dielectric 142 may be of or include any suitable material(s).

In many embodiments, dielectric 143 has an etch selectivity with adjacent structures, e.g., dielectrics 141, 142. Dielectric 143 may act as a mask or cap layer, as will be described later, e.g., at FIG. 4 and methods 400. In some embodiments, cap dielectric 143 is on and over dielectric 142, etc., including over materials and structures laterally adjacent to dielectric 142. For example, dielectrics 141, 142 may be between sidewalls (e.g., in the positive and/or negative x-directions) that dielectric 143 is over. In some embodiments, dielectric 143 is on and over dielectric 141, and no dielectric 142 is present between dielectrics 141, 143. In many embodiments, dielectric 143 includes nitrogen. In some such embodiments, dielectric 143 includes silicon (e.g., in a nitride of silicon, SiₓN_{y}). Dielectric 143 may be of or include any suitable material(s). In many embodiments, dielectric 143 has a thickness greater than a thickness of dielectric 142.

Conformal layer 144 includes a dielectric that may be distinct from each of dielectrics 141, 142, 143. In the embodiment of FIG. 1A, layer 144 is conformally on each sidewall 111 of all source or drain bodies 110. The term "sidewall" refers to a surface between top and bottom portions of bodies 110 and does not imply that that the surface is planar or perfectly vertical. For example, sidewalls 111 may be non-planar surfaces having multiple curves, e.g., being convex or bulging outwards where level with a nanoribbon region 120 and being concave between nanoribbon regions 120.

Two thicknesses of layer 144 are between each pair of adjacent bodies 110, one thickness on each sidewall 111 between the pair of bodies 110. In the case of a pair not coupled by metallization structure 130 (e.g., the central pair in the view of FIG. 1A), dielectric 141 is between the two thicknesses of layer 144 on adjacent sidewalls 111. In some such embodiments (as is shown in FIG. 1A), conformal layer 144 is under dielectric 141 between adjacent pairs of sidewalls 111, for example, in a continuous layer 144 connecting the two thicknesses of layer 144. In some embodiments, conformal layer 144 is a continuous layer 144 between adjacent pairs of sidewalls 111 of bodies 110, on a sidewall of trench 115 connecting the two thicknesses of layer 144.

In many embodiments, conformal layer 144 is a liner layer 144, e.g., protecting source and drain bodies 110 from dielectric 141. In some such embodiments, dielectric 141 is or includes an oxide that may react with (for example, degrade) bodies 110. In some embodiments, layer 144 has an etch selectivity with adjacent structures, e.g., dielectric 141, which may serve an etch-stop function, for example, when removing portions of dielectric 141. In some embodiments, layer 144 includes, or has a composition similar to, dielectric 143. In many embodiments, layer 144 includes nitrogen. In some such embodiments, layer 144 includes silicon (e.g., in a nitride of silicon, SiₓN_{y}). In many embodiments, dielectric 143 has a thickness greater than a thickness of layer 144. In many embodiments, dielectric 142 has a thickness greater than a thickness of layer 144. In some embodiments, layer 144 has a thickness of 4 nm or less.

Layer 144 may be a conformal liner layer 144 in trench 115. Layer 144 may be conformal over bodies 110. In some embodiments, layer 144 is conformal over spacer(s) 121 and/or 122, for example, in a bottom of trench 115 (as shown in FIG. 1A) and sidewalls of trench 115 (e.g., in both the positive and negative x-directions from the viewing plane). Device 100 may include one or both of spacers 121, 122, which may be conformal layers of dielectric material, e.g., lining the sidewalls and bottom of trenches 115. Trench 115 may include conformal spacers 121, 122, or trench 115 may be within spacers 121, 122. Spacers 121, 122 may be layers of dielectric material(s) and may have an etch selectivity. For example, one of spacers 121, 122 may include oxygen (and/or more oxygen than the other), and the other of spacers 121, 122 may include nitrogen (and/or more nitrogen than the one). In many embodiments, spacers 121, 122 include silicon.

Source and drain material bodies 110 are electrically and physically coupled to ends of channel regions 120. Source and drain bodies 110 are impurity doped regions., e.g., semiconductor material doped with one or more electrically active impurities. In many embodiments, bodies 110 are mostly silicon or mostly silicon germanium and with small quantities of donor or acceptor dopants. Impurity doped bodies 110 may have increased charge-carrier availabilities and associated conductivities. Source or drain material body 110 may be doped with an opposite type (e.g., n- or p-type). Source or drain body 110 may include a predominant semiconductor material, and one or more n-dopants (such as phosphorus, arsenic, or antimony) or p-type impurities (such as boron or aluminum). Other dopant materials may be used. Any suitable means of formation may be used. Material body 110 may be epitaxially grown semiconductor regions, for example, of a Group IV semiconductor material (e.g., Si, Ge, or SiGe or GeSn alloy). Other semiconductor materials may be employed. Material body 110 is substantially crystalline. Source and drain material bodies 110 may be polycrystalline, e.g., having long-range order at least adjacent ends of channel regions 120 and merging or joining into a unitary body with few grain boundaries. Source and drain material bodies 110 may be substantially monocrystalline, for example, where coupling fin channel regions 120.

Source and drain bodies 110 may include an interface layer, e.g., with very low contact resistivity and for contacting metallization structures 130 over bodies 110. In many embodiments, source or drain bodies 110 include a highly conductive interface layer having one or more metals. For example, material bodies 110 of silicon (including bodies 110 of silicon germanium) may have a metal alloyed with silicon in an interface layer at a top of body 110. In some embodiments, body 110 includes an interface layer having titanium and silicon. In some embodiments, body 110 includes an interface layer having silicon and one of cobalt, nickel, ruthenium, platinum, or tungsten. Other metals may be deployed.

In many embodiments, at least some of transistor structures 101 are physically symmetrical about channel regions 120, and identifiers for source and drain material bodies 110 may be reversed interchangeably in many contexts. However, the classification of source and drain material body 110 may be by the electrical relationships of transistor structure 101 and body 110 to other components in a given circuit (e.g., and the consequent direction of current flow through structure 101 and material body 110).

Channel regions 120 may be any suitable structure. In the example of FIG. 1A, channel regions 120 are nanoribbon regions 120 over fins 125 in or on substrate 199, and source and drain bodies 110 are each coupled with multiple nanoribbon regions 120 in stacks. In some embodiments, stacks of regions 120 include more or fewer nanoribbons (e.g., three nanoribbons each). In some embodiments, rather than stacks, source and drain bodies 110 are coupled by single nanoribbon channel regions 120. Nanoribbon channel regions 120 may have any suitable width, including sufficiently narrow or wide widths to be characterized as nanowires or nanosheets, respectively. Nanoribbon regions 120 of complementary types (e.g., in n- and p-type structures 101) may have accordingly different widths, for example, to align conductances of transistor structures 101. In some embodiments, regions 120 are nanoribbons formed from fins 125 (e.g., as separated layers of fins 125). In other embodiments, channel regions 120 are in fins 125, for example, in continuous channel regions spanning a same height as the stacks of regions 120 shown in FIG. 1A.

Channel regions 120 may be of any suitable material(s), for example, one or more semiconductor materials. Channel regions 120 may be of silicon, germanium, silicon germanium (e.g., Si₁₋ₓGeₓ), a III-V alloy material (such as gallium arsenide or gallium nitride), or other materials. Suitable materials may include two-dimensional (2D) materials (e.g., transition-metal dichalcogenides (TMD)) or semiconductor films (e.g., of certain metal oxides).

Metallization structure 130 is a conductive structure (e.g., including one or more metals) that contacts source or drain bodies 110. Structures 130 may couple source and drain bodies 110 (and transistor structures 101) to interconnect layers, e.g., in an interconnect network over transistor structures 101. Structures 130 may contact each of source and drain bodies 110 at an interface layer. Metallization structures 130 may include any suitable material(s). In some embodiments, structures 130 include a stack of two or more metal layers, e.g., where at least one included metal layer is a liner (e.g., conformal) layer 132, and at least one metal layer is a fill metal layer 131. In many embodiments, structures 130 include one or more of copper, gold, tantalum, cobalt, tungsten, ruthenium, molybdenum, aluminum, and nickel, including in alloys. In some embodiments, structures 130 include nitrides of metals, e.g., tantalum and titanium. Structures 130 may include other electrically conductive materials, including non-metals.

In the embodiment of FIG. 1A, each metallization structure 130 is over and between a pair of source or drain bodies 110 and couples the pair of bodies 110 and the corresponding transistor structures 101. Each metallization structure 130 in the example of FIG. 1A includes an intervening portion 133 between the corresponding pair of source or drain bodies 110. Layers 144 may be on sidewalls 111 of each body 110, e.g., on both sides of intervening portions 133, between each intervening portion 133 and both source or drain bodies 110 portion 133 is between. As in the example of FIG. 1A, intervening portions 133 may be down to spacer 122 between bodies 110. Layers 144 on adjacent sidewalls 111 between coupled bodies 110 may be discontinuous under dielectric 141, between the adjacent sidewalls 111. Layers 144 on adjacent sidewalls 111 between coupled bodies 110 may be interrupted by intervening portion 133 between adjacent sidewalls 111. In some embodiments, intervening portions 133 are down to spacer 121 between bodies 110.

Substrate 199 may include any suitable material or materials. In some examples, substrate 199 may include monocrystalline silicon (including silicon on insulator (SOI)), polycrystalline silicon, germanium, silicon germanium, a III-V alloy material (e.g., gallium arsenide), a silicon carbide (e.g., SiC), a sapphire (e.g., Al₂O₃), or any combination thereof. Substrate 199 may refer specifically to a base material (for example, a thick base or layer of semiconductor material) that other materials (such as metals and dielectrics) are built up on. In some contexts, substrate 199 may refer to a base material layer and any build-up layers, etc., over the base. In many embodiments, substrate 199 includes a semiconductor material under bodies 110 and regions 120, and channel regions 120 are of the same semiconductor material. In some such embodiments, trenches 115 are cut through silicon channel regions 120 (e.g., nanoribbons) and into a silicon substrate 199. Substrate 199 may also include other semiconductor materials, metals, dielectrics, dopants, and other materials commonly found in semiconductor substrates.

Isolation 191 is in, on, or over substrate 199, between the bases of fins 125. Isolation 191 is a dielectric material and isolates channel regions 120 from channel regions 120 in or over adjacent fins 125. Isolation 191 may include a fill or bulk portion within a liner layer portion, as shown in FIG. 1A. Isolation 191 is advantageously a low-K dielectric material. In many embodiments, isolation 191 includes oxygen. In some such embodiments, isolation 191 includes silicon (e.g., in an oxide of silicon, SiₓO_{y}).

FIG. 1B illustrates a cross-sectional profile view D-D' of adjacent source and drain material bodies 110 over substrate 199 and in transistor structures 101 and metallization structures 130 over individual bodies 110. The embodiment shown in FIG. 1B is similar to that of FIG. 1A, with each body 110 in a distinct n- or p-type transistor structure 101. Unlike the embodiment of FIG. 1A, adjacent n- and p-type structures 101 are not paired or coupled by the shown structures 130, which are separately on each of the respective source or drain bodies 110 of each structure 101.

As in the embodiment of FIG. 1A, metallization structures 130 are over and contact source or drain bodies 110 in respective structures 101. In the embodiment of FIG. 1B, stacks 140 of dielectrics 141, 142, 143 are between and separate adjacent bodies 110. Each of the four shown source or drain bodies 110 is contacted by an unshared one of four structures 130 over the body 110. Stacks 140 of dielectrics 141, 142, 143 are between and separate adjacent structures 130. For example, the center stack 140 is between the inner two bodies 110 and between the inner two structures 130. Each of the inner bodies 110 and structures 130 is between the central stack 140 and a next stack 140. Each pair of bodies 110 and structures 130 to either side of center stack 140 is separated by a stack 140 between the two bodies 110 and two structures 130. Each of the outer bodies 110 and structures 130 is between an outer stack 140 and a next stack 140 towards the center from the outer stack 140.

A conformal layer 144 is on sidewalls 111 and between each stack 140 and the two bodies 110 that stack 140 is between. Dielectric 141 in each stack is between conformal layer 144 on sidewalls 111 of both bodies 110 that stack 140 is between. For example, dielectric 141 in the center stack 140 is between the inner pair of bodies 110 and between layer 144 on the inner pair of sidewalls 111 of the inner pair of bodies 110. Layer(s) 144 are between center stack 140 and each of the inner pair of bodies 110. Dielectric 141 in a next stack 140 over is between each the left or right pair of bodies 110 and between layers 144 on the pair of sidewalls 111 internal to that pair of bodies 110. Layer(s) 144 are between that next stack 140 over and each of the adjacent pair of bodies 110. Conformal layer 144 is continuous under dielectric 141 in each stack between adjacent pairs of sidewalls 111 of adjacent bodies 110, for example, in a continuous layer 144 connecting thicknesses of layer 144 on adjacent, facing sidewalls 111.

FIGS. 2A, 2B, and 2C illustrate plan views of IC device 100 having dielectric stacks 140 between adjacent contact structures 130, including dielectric 143 over trenches 115, transistor structures 101, and trench isolations 250, in accordance with some embodiments. Dielectric stacks 140 are in trenches 115, between aligned metallization structures 130. Trench isolations 250, e.g., fin trench isolations (FTI), are between some trenches 115, extending in the y-directions, in parallel with structures 130. The structures shown may continue beyond the edges of views of FIGS. 2A-2C, for example, isolations 250 in the y-directions and regions 120 in the x-directions.

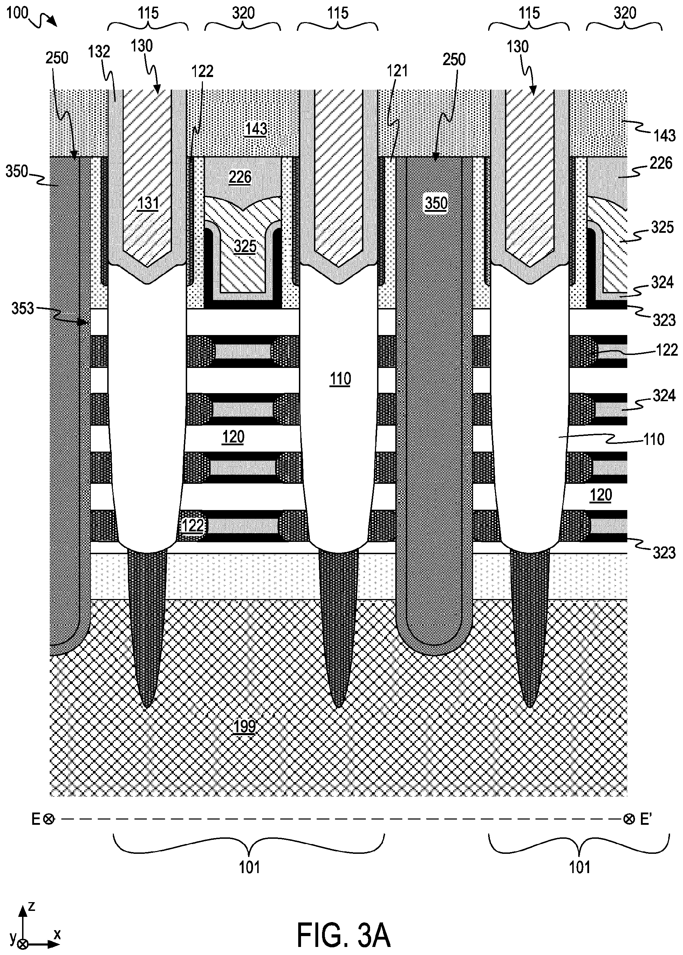

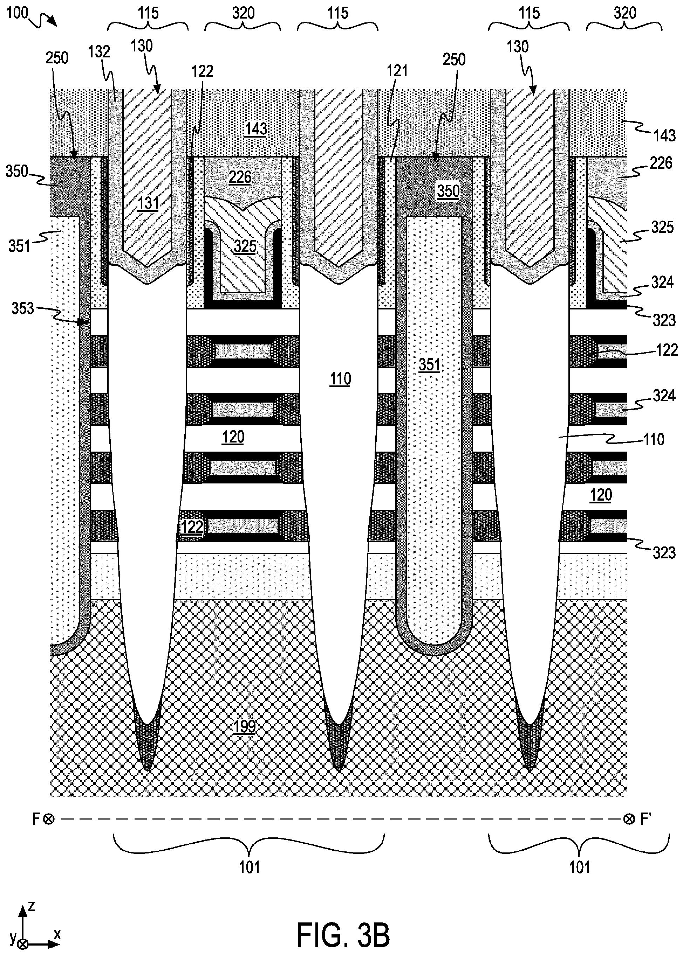

FIG. 2A, rather than a single x-y plane, shows a plan view of selected structures at various depths in device 100. Some structures and materials (e.g., dielectrics 141, 142, or 143) are not shown in the view of FIG. 2A for illustrative purposes, for example, to show the relative orientations of structures 101, 130, etc., without completely obscuring channel regions 120. The orientations and locations of profile views A-A', D-D', E-E', F-F' of FIGS. 1A, 1B, 3A, and 3B, respectively, are indicated in FIGS. 2A-2C. Profile views A-A' and D-D' are fin cuts of y-z planes through structures 130, as shown at FIGS. 1A and 1B. Profile views E-E' and F-F' are gate cuts of x-z planes through bodies 110 and longitudinally through channel regions 120, as shown at FIGS. 3A and 3B. Trench isolations 250 may be between and separating arrays of transistor structures 101. In some embodiments, isolations 250 are between and separate arrays of identical (or at least similar) transistor structures 101. For example, the view A-A' of FIG. 1A may also illustrate the four structures 101 in the positive x-direction from view D-D', and isolation 250 may be between and separate arrays of identical transistor structures 101.

FIG. 2A illustrates the layout of channel regions 120 under gate contacts 226 and metallization structures 130 (over source and drain bodies). Gate contacts 226 extend in the y-directions, parallel and between metallization structures 130, e.g., together in transistor structures 101, over channel regions 120. Four transistor structures 101 include channel regions 120 (e.g., four stacks of nanoribbon channel regions 120) coupled to source and drain bodies under the two metallization structures 130 of view A-A' and FIG. 1A, the same channel regions 120 coupled to source and drain bodies under the four metallization structures 130 of view D-D' and FIG. 1B. The four structures 101 may be organized in two CMOS inverters, e.g., with complementary structures 101 coupled by shared structures 130 and shared gate contacts 226. The two metallization structures 130 of view A-A' are mechanically parallel with the four metallization structures 130 of view D-D'.

Device 100 may include isolations 250 extending in the y-directions, parallel and between metallization structures 130, through or between channel regions 120. In some embodiments, isolations 250 interrupt or break the structures having channel regions 120, for example, stacks of nanoribbons that include channel regions 120. In some such embodiments, interrupted or broken nanoribbons contact isolations 250 on both sides (e.g., in the positive and negative x-directions) of isolations 250, and the interrupted or broken nanoribbons contact bodies 110 on both sides (e.g., in the positive and negative x-directions) of isolations 250 (e.g., under structures 130). Isolations 250 are between (e.g., in the x-directions) and separate transistor structures 101, for example, the four structures 101 in views A-A' and D-D' from four structures 101 in the positive x-direction.

IC device 100 (and structures 101) may be coupled to one or more power supplies on or through a host component 299 coupled to substrate 199. Host component 299 is a planar platform or substrate and may include dielectric and metallization structures. Host component 299 may mechanically support, and electrically couple to, substrate 199. At least one side of host component 299 includes interconnect interfaces, e.g., for soldering or direct bonding to one or more IC dies or other substrates. The opposite side of host component 299 may include similar interfaces or, e.g., copper pads for socketing or solder bumps for bonding to another substrate or host component, for example, a printed circuit board. Host component 299 may be any platform with interconnect interfaces, such as a package substrate or interposer, another IC die, etc. Host component 299 may itself be a die or an insulating substrate. Host component 299 may bond to any platform, such as a package substrate or interposer, another IC die, etc. In many embodiments, substrate 199 is an IC die, and host component 299 is a package substrate or interposer.

FIG. 2B shows view B-B' at the top of trenches 115, horizontally through dielectric 142 and dielectric stacks 140 between adjacent metallization structures 130. Trenches 115 are indicated by dotted borders extending in the y-directions. Dielectric 142 is over dielectric 141 (not shown) in stacks 140. In some embodiments, dielectric 142 is not present (e.g., in embodiments where device 100 is planarized down to dielectric 141 before a deposition of dielectric 143), and dielectric 141 is between structures 130 in trenches 115 in the x-y plane of view B-B'. Dielectrics 141, 142 are in trench 115, between and in contact with sidewalls of trench 115 (e.g., of spacers 122). Dielectric 143 (not shown) is over dielectrics 141, 142 in stacks 140, but may extend over and beyond sidewalls of trench 115, e.g., in both the positive and negative x-directions (as described at FIG. 2C). Trench 115 is between adjacent gate structures (including gate contacts 226) over channel regions 120. Trenches 115 extend in the y-directions, between parallel sidewalls (e.g., of spacers 122) adjacent the gate structures, the sidewalls also extending in the y-directions. Spacers 121, 122 may form and contain trenches 115. Spacers 121 may be on sidewalls of gate structures (including gate contacts 226) and below trenches 115 and spacers 122. Spacers 122 may be on sidewalls of spacers 121 and below trenches 115.

Metallization structures 130 are in trenches 115 with dielectric 142 and dielectric stacks 140 between adjacent metallization structures 130. Dielectric stacks 140 isolate adjacent metallization structures 130 in a same trench 115. Spacers 121, 122 isolate metallization structures 130 from adjacent gate structures (including gate contacts 226). Adjacent gate contacts 226, e.g., between a pair of trenches 115, may be isolated by a dielectric material 246 between contacts 226, for example, a low-K dielectric, such as (or similar to) isolation 191.

Isolations 250 extend in the y-directions, parallel and between spacers 121, 122 and structures 130, as well as in the z-direction, down through channel regions 120. Isolations 250 may be of a dielectric material that isolates (e.g., electrically) between adjacent structures, such as adjacent structures 101, 130 and source and drain bodies under structures 130. For example, isolations 250 isolate between transistor structures 101 and adjacent structures 101, e.g., in the x-directions. In many embodiments, the dielectric material of isolation 250 includes nitrogen. In some such embodiments, the dielectric material of isolation 250 includes silicon (e.g., in a nitride of silicon, SiₓN_{y}). In some embodiments, the dielectric material of isolation 250 includes oxygen. In some such embodiments, the dielectric material of isolation 250 includes silicon (e.g., in an oxide of silicon, SiₓO_{y}). In some embodiments, the dielectric material of isolation 250 includes nitrogen and oxygen. Note that profile views E-E' and F-F' at FIGS. 3A and 3B, respectively, are through and show isolations 250 in x-z cross-sectional viewing planes.

FIG. 2C illustrates view C-C' horizontally through dielectric 143. Dielectric 143 in FIG. 2C is continuous over trenches 115, spacers 121, 122, dielectrics 141, 142, and isolation 250 (e.g., shown in FIG. 2B). Dielectric 143 is continuous over dielectrics 141, 142 of trench 115 and extends over and beyond sidewalls of trench 115 (e.g., spacers 122) in both the positive and negative x-directions.

Dielectric 143 may serve as a mask material during processing of device 100, e.g., during the formation of metallization structures 130 and gate vias or contacts 228. For example, structures 130 may be formed by etching dielectrics 141, 142 through patterned mask dielectric 143 and by depositing metallization in the formed openings. Gate vias or contacts 228 may be formed on or as part of a gate structure by depositing metallization in patterned openings in patterned mask dielectric 143. In the embodiments of FIGS. 2B and 2C, gate vias or contacts 228 have a smaller cross-sectional area than gate contacts 226 and may be formed in a separate operation after gate contacts 226. Note that profile views E-E' and F-F' at FIGS. 3A and 3B, respectively, are through dielectric 143 to either side (e.g., in the y-directions) of gate vias or contacts 228.

FIGS. 3A and 3B illustrate cross-sectional profile views E-E' and F-F' of IC device 100 having cap dielectric 143 over gate contacts 226 and enhanced contact structures 130 on source and drain bodies 110 and through cap dielectric 143, in accordance with some embodiments. The x-z planes of profile views E-E' and F-F' are through bodies 110 and longitudinally through channel regions 120. Gate structures 320 are between adjacent source and drain bodies 110 and metallization structures 130. In the example(s) of FIGS. 3A and 3B, isolations 250 isolate adjacent trenches 115 and transistor structures 101, extending down through nanoribbon regions 120. Isolations 250 are between and parallel to adjacent trenches 115 (e.g., extending in the y-directions). FIGS. 3A and 3B show similar views E-E' and F-F' in x-z viewing planes through different (e.g., complementary) structures 101 and corresponding trench isolations 250. As shown at FIG. 2B, views E-E' and F-F' are between stacks 140 (not shown in FIGS. 3A and 3B), and stacks 140 are between views E-E' and F-F'. Dielectrics 141, 142 in stacks 140 (not shown in FIGS. 3A and 3B) may be in front of and behind views E-E' and F-F'.

FIG. 3A illustrates source and drain bodies 110 and metallization structures 130 in trenches 115. Dielectrics 141, 142 (e.g., not shown in FIG. 3A, but as described at FIGS. 1A, 2B) are in trench 115, e.g., in both the positive and negative y-directions of the viewing plane. Dielectric 143 is over dielectrics 141, 142 (e.g., out of the viewing plane), but extends over and beyond sidewalls of trench 115, as shown, in both the positive and negative x-directions. Trenches 115 extend in the y-directions, between parallel sidewalls of adjacent gate structures 320.

Transistor structure 101 includes a gate electrode 324 and gate dielectric 323 in gate structure 320 over and adjacent channel regions 120. Gate structure 320 includes gate dielectric 323 on channel region 120, e.g., on and around each nanoribbon. Gate structure 320 includes gate electrode 324 between adjacent metallization structures 130 (e.g., over each source or drain body 110), and with gate dielectric 323 between gate electrode 324 and each channel region 120 (e.g., nanoribbons). Gate dielectric 323 provides electrical insulation between channel region 120 and gate electrode 324, and enables electrostatic control of channel region 120 (and of the conduction of region 120) by an electric signal on gate electrode 324. Conduction of channel region 120 may electrically couple adjacent source and drain bodies 110 and the respective metallization structures 130 coupled to bodies 110. Gate structure 320 may include a fill or bulk portion 325 that couples a layer of gate electrode 324 with gate contact 226. In the embodiments of FIG. 3A, dielectric 143 is visible in front of (e.g., in the y-directions), and obscuring, gate vias or contacts 228, which couple gate electrode 324, etc., to interconnect layers, e.g., in an interconnect network over transistor structures 101.

Gate dielectric 323 may have more than one layer. Gate dielectric 323 may be of any suitable material(s). The one or more layers of gate dielectric 323 may include a silicon oxide, silicon dioxide (SiO₂), a silicon oxynitride, etc. Advantageously, gate dielectric 323 includes a high-permittivity ("high-K") dielectric (for example, having a dielectric constant over 6). A high-K dielectric material may include one or more of various elements, such as hafnium, silicon, oxygen, titanium, tantalum, lanthanum, aluminum, zirconium, barium, strontium, yttrium, lead, scandium, niobium, and zinc. Gate dielectric 323 may include a dopant, e.g., for elevated permittivity.

Gate electrode 324 is on gate dielectric 323 and may include of at least one of a p- or an n-type work function metal (WFM), depending on whether the transistor is a pMOS or nMOS transistor. In some embodiments, gate electrode 324 is a stack of two or more metal layers, where one or more metal layers are WFM layers and at least one metal layer is a fill metal layer. In a pMOS transistor, for example, metals that may be utilized for gate electrode 324 include, but are not limited to, ruthenium, palladium, platinum, cobalt, nickel, and conductive metal oxides, e.g., ruthenium oxide. A p-type metal layer will enable the formation of a pMOS gate electrode 324 with a work function that is between about 4.9 eV and about 5.2 eV. These or other metals may be deployed in gate electrode 324 in an nMOS transistor, including hafnium, zirconium, titanium, tantalum, aluminum, alloys of these metals, carbides of these metals (such as hafnium carbide, zirconium carbide, titanium carbide, tantalum carbide), etc. An n-type metal layer will enable the formation of an nMOS gate electrode 324 with a work function that is between about 3.9 eV and about 4.2 eV.

Spacers 121, 122 provide isolation between source and drain material bodies 110 and gate electrodes 324. Spacer 122 is in contact with bodies 110 and gate electrodes 324. Spacer 122 is also between and in contact with channel regions 120 between source and drain bodies 110 and gate electrodes 324. Spacer 122 is in contact with structures 130 (e.g., at layer 132) and provides isolation between metallization structures 130 and gate contact 226 and electrode 324. Spacer 121 is in contact with gate contact 226 and electrode 324 (and portion 325) and provides isolation between metallization structures 130 and gate contact 226 and electrode 324. Spacers 121, 122 may be of any suitably insulating material(s), advantageously a low-K dielectric to minimize parasitic coupling between adjacent bodies 110 and gate electrodes 324, and between adjacent structures 130 and electrodes 324. In some embodiments, spacer 122 in contact with structure 130 is of the same electrically insulating material as spacers 122 in contact with body 110 and gate electrodes 324 between channel regions 120. In some embodiments, a dielectric layer having a same composition as layer 144 is between metallization structures 130 and spacer 122, over body 110.

Trench isolations 250 are between source and drain bodies 110. In the example of FIG. 3A, bodies 110 are p-type source and drain bodies 110. Isolation 250 may include a conformal liner layer of dielectric 350 (e.g., forming sidewalls 353 of isolation 250) and a fill or bulk portion of dielectric 350. Isolation 250 may be an integrated structure of dielectric 350, e.g., without a discrete interface between layer and fill portions of dielectric 350. Dielectric 350 may have an advantageously low relative permittivity, e.g., with a dielectric constant less than at least 9. In some embodiments, dielectric 350 has a dielectric constant less than 6. In many embodiments, dielectric 350 includes nitrogen. In some such embodiments, dielectric 350 includes silicon (e.g., in a nitride of silicon, SiₓN_{y}). Dielectric 350 including a nitride of silicon may advantageously provide strain (e.g., compressive strain) to channel regions 120, which may increase electrical conductivity through regions 120. Dielectric 350 may be of or include any suitable material(s). Isolations 250 interrupt or break stacks of nanoribbon structures having channel regions 120. Interrupted or broken nanoribbons contact isolations 250 between spacers 122 on both sides (e.g., in the positive and negative x-directions) of isolations 250, and the interrupted or broken nanoribbons contact bodies 110 between spacers 122 on both sides (e.g., in the positive and negative x-directions) of isolations 250 (e.g., under structures 130). Isolations 250 are between (e.g., in the x-directions) and separate transistor structures 101.

FIG. 3B shows trench isolations 250 of multiple dielectrics 350, 351 between n-type source and drain bodies 110. In some embodiments, isolations 250 include a liner layer of dielectric 350 (e.g., forming sidewalls 353) and a fill or bulk portion of dielectric 351. Dielectric 351 may be a low-K dielectric 351. In many embodiments, dielectric 351 includes oxygen. In some such embodiments, dielectric 351 includes silicon (e.g., in an oxide of silicon, SiₓO_{y}). Dielectric 351 may offer different strain characteristics, which may provide improved conductivity through channel regions 120.

FIG. 4 is a flow chart of methods 400 for forming enhanced contact structures in and through dielectric stacks with excellent etch selectivities, in accordance with some embodiments. Methods 400 include operations 410-490. Some operations shown in FIG. 4 are optional. Additional operations may be included. FIG. 4 shows an example sequence, but the operations can be done in other orders as well, and some operations may be omitted. Some operations can also be performed multiple times before other operations are performed. For example, first and second dielectrics may be deposited between sidewalls in any number of trenches (e.g., at operations 420, 440). Multiple mask layers may be deployed. Some operations may be included within other operations so that the number of operations illustrated FIG. 4 is not a limitation of the methods 400.

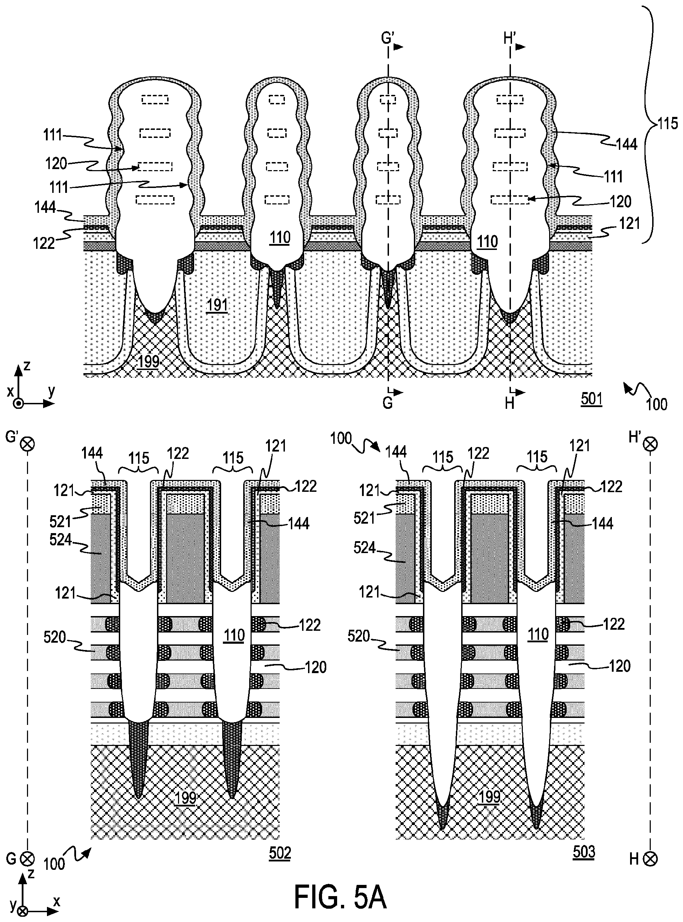

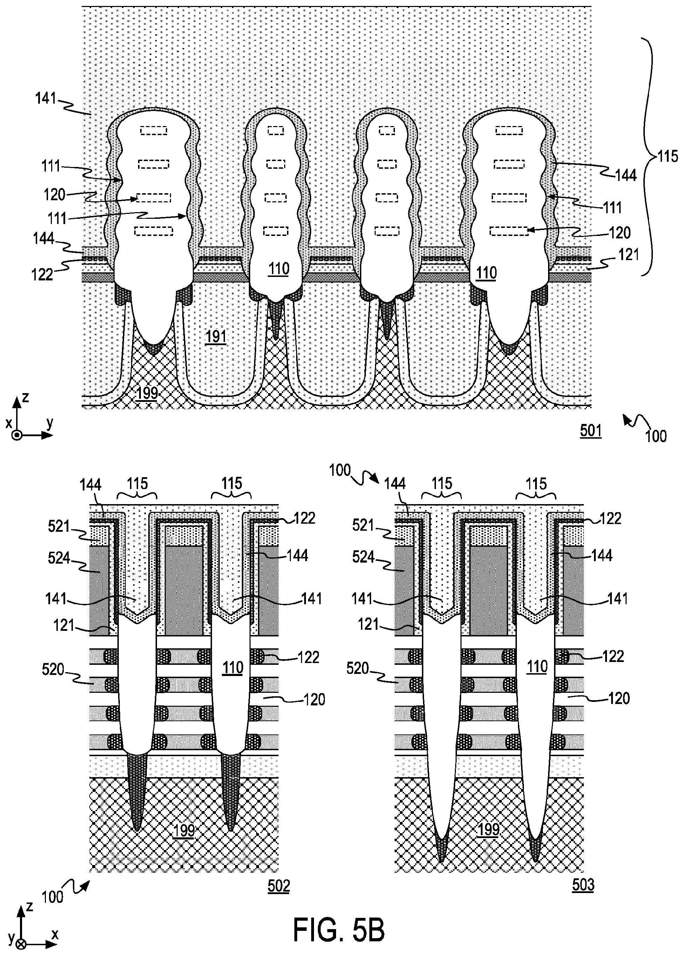

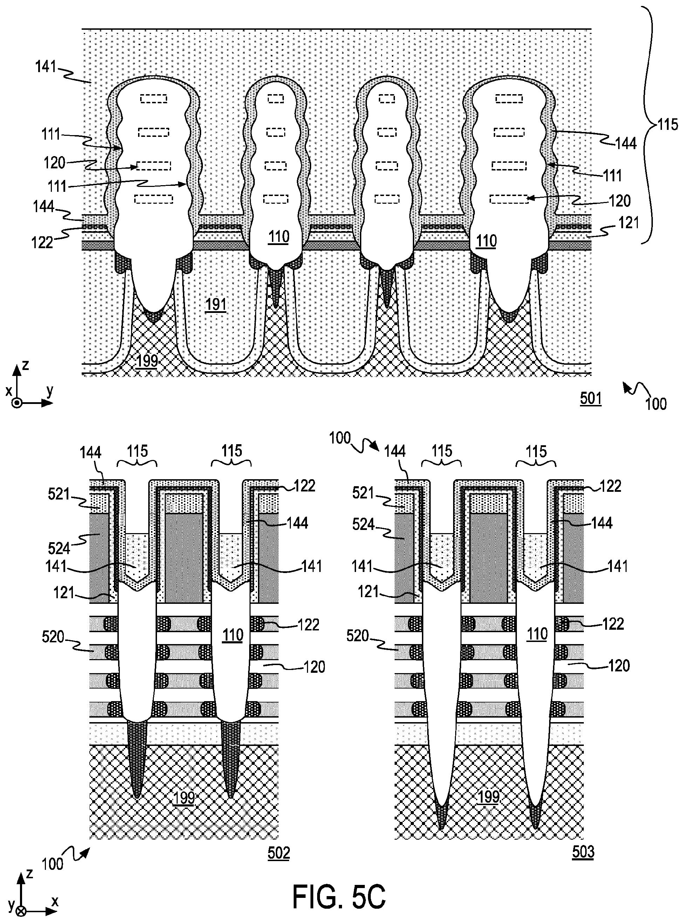

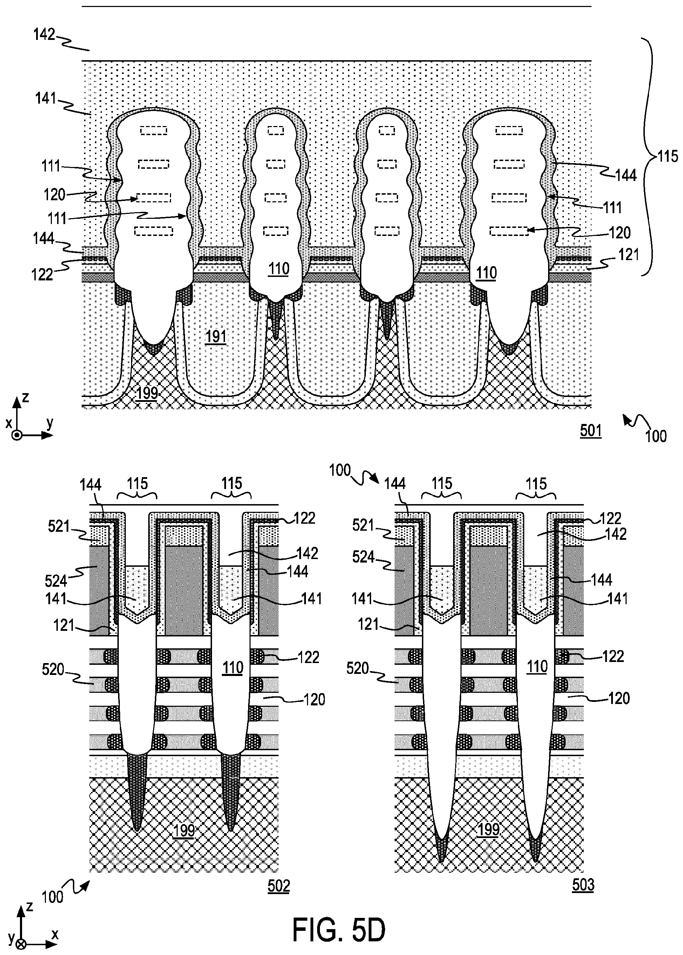

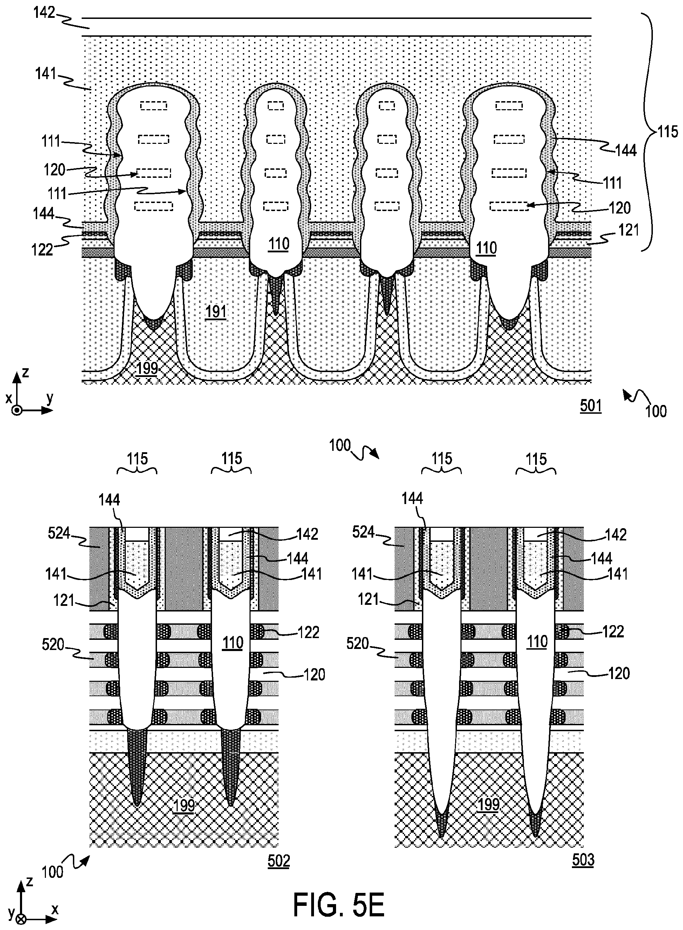

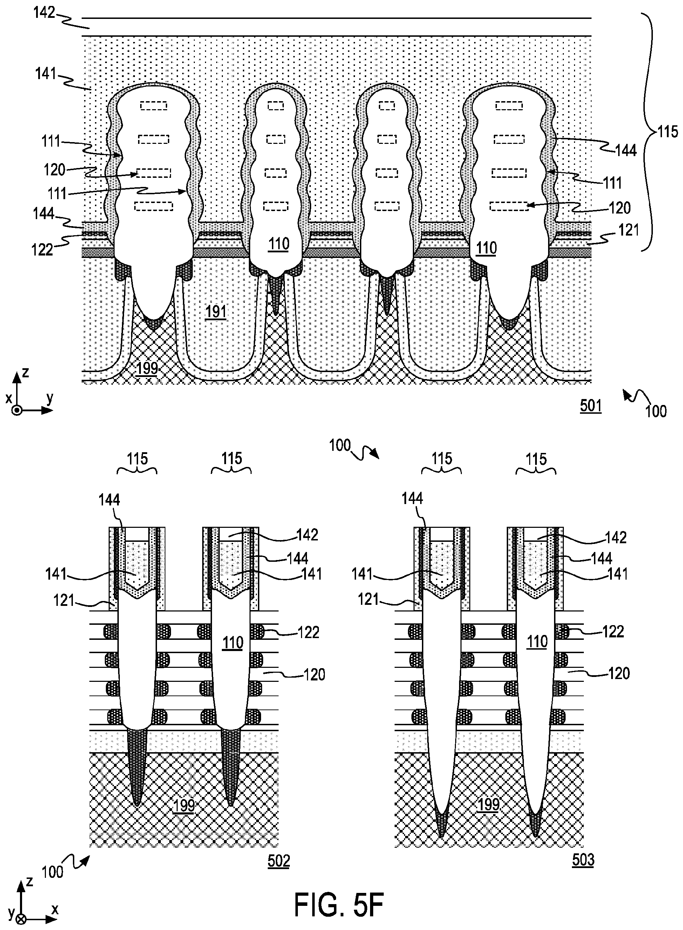

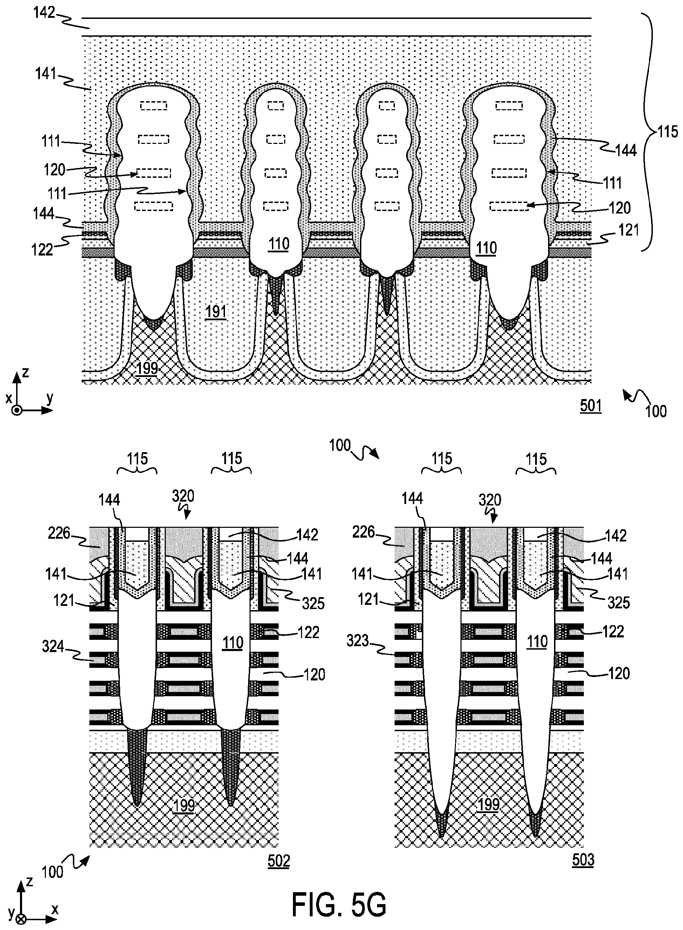

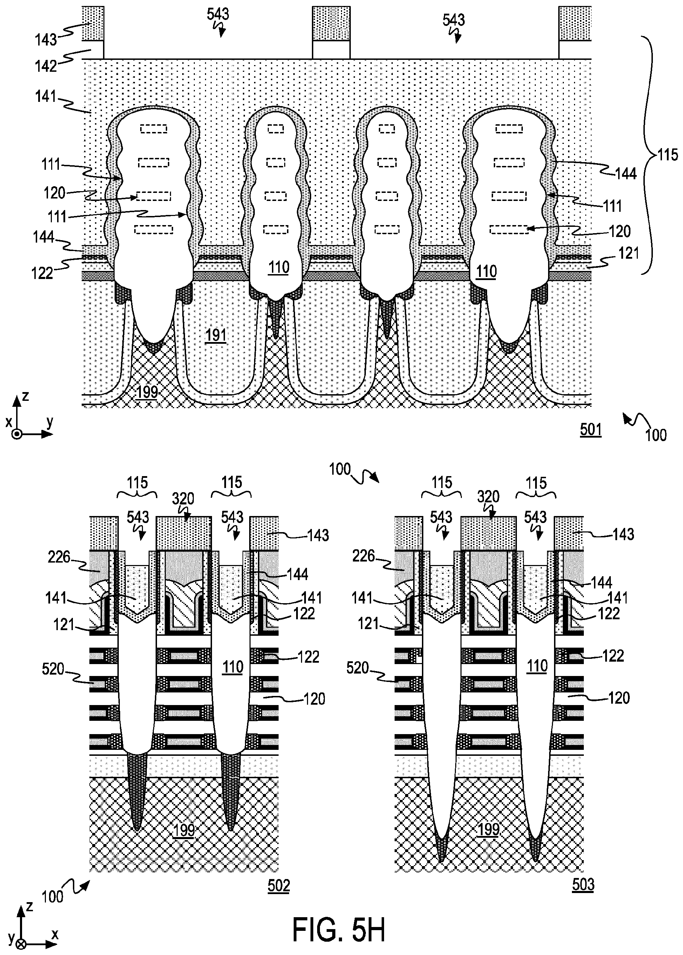

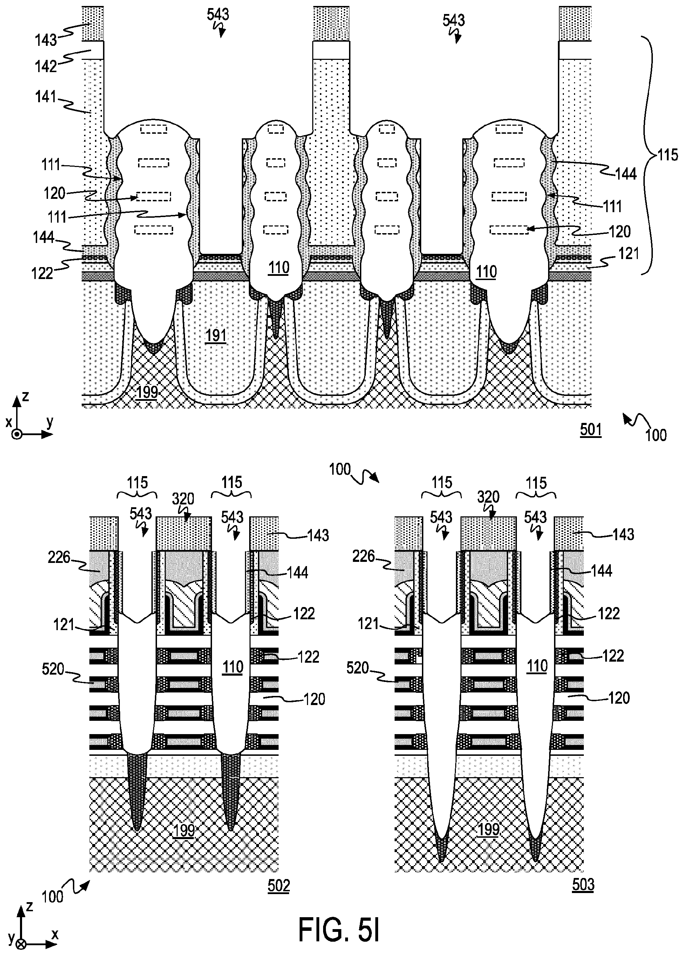

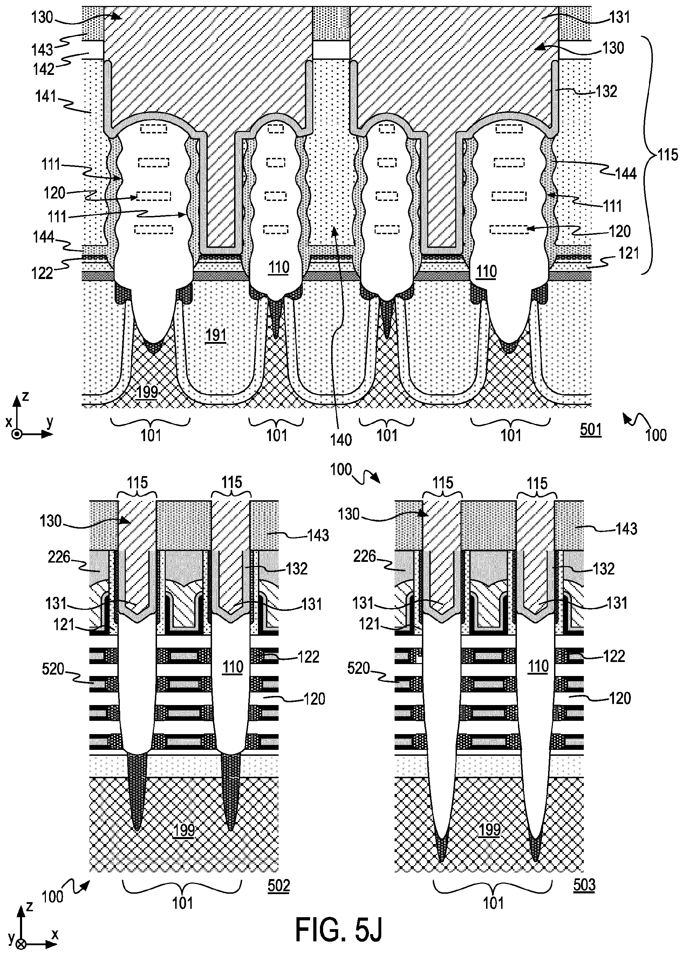

FIGS. 5A, 5B, 5C, 5D, 5E, 5F, 5G, 5H, 5I, and 5J illustrate cross-sectional profile views of dielectric stacks 140 having dielectrics 141, 142, 143 with superior etch selectivities between transistor structures 101 and enhanced contact structures 130, at various stages of manufacture, in accordance with some embodiments. FIGS. 5A-5J show possible examples of intermediate structures during an embodiment of a practice of methods 400 of FIG. 4.

Returning to FIG. 4, methods 400 begin at operation 410 with optionally depositing a conformal layer over a substrate. The substrate may be received having transistor structures at intermediate stages of manufacture. In some embodiments, the substrate includes source and drain material bodies coupled to channel regions. The source and drain bodies may be semiconductor bodies (for example, much as bodies 110 are described at FIG. 1A and elsewhere). In some embodiments, the source and drain bodies are in trenches between gate structures on and over the channel regions, and the gate structures are between source and drain bodies in adjacent trenches. For example, the gate structures may be dummy or sacrificial gate structures (e.g., of polycrystalline silicon), gate structures with metal gate electrodes on a gate dielectric, etc. The trenches may have sidewalls on or formed by the gate structures, for example, sidewalls of spacer dielectrics over or on the gate structures. In some embodiments, a thin dielectric layer is conformally deposited on and over the source and drain bodies, e.g., on tops and sidewalls of the source and drain bodies (for example, much as layer 144 is described at FIG. 1A and elsewhere, including sidewalls of and between the source and drain bodies). In many embodiments, a dielectric layer is conformally deposited on and over dummy or sacrificial gate structures between the source and drain bodies.

The conformally deposited dielectric layer may have any suitable composition (for example, much as layer 144 is described at FIG. 1A and elsewhere) and may be deposited by any suitable means (e.g., chemical vapor deposition (CVD), an atomic layer deposition (ALD), etc.). The conformally deposited dielectric layer may have a composition different from a composition of a bulk dielectric (e.g., subsequently) deposited on the conformal dielectric layer, and there may be an etch selectivity between the bulk dielectric and the conformal dielectric layer (for example, much as described at FIG. 1A and elsewhere between dielectric 141 and layer 144). In some embodiments, the bulk dielectric includes silicon and no oxygen or nitrogen, and the conformal dielectric layer includes silicon and nitrogen.

FIG. 5A illustrates dielectric layer 144 conformally over source and drain material bodies 110 in trench 115 in a workpiece or device 100, in accordance with some embodiments, for example, following a performance of depositing operation 410. In FIG. 5A (as in FIGS. 5B-5J), view 501 shows a longitudinal cross-section of a single trench 115 having multiple source or drain bodies 110, and parallel views 502, 503 (both orthogonal to view 501) show transverse cross-sections of multiple trenches 115 (and longitudinal cross-sections of channel regions 120 coupling pairs of bodies 110, e.g., with a body 110 in each trench 115). The orientation of x-z profile views G-G' and H-H' of views 502, 503, respectively, are indicated in the y-z plane of view 501. For example, views 502, 503 may be through adjacent, complementary structures spanning between adjacent trenches 115.

View 501 illustrates dielectric layer 144, which is conformally over bodies 110 (e.g., on sidewalls 111 of bodies 110) and spacers 121, 122 at a bottom of trench 115. Spacers 121, 122 are over isolation 191 below trench 115 and in, on, or over substrate 199. Source and drain bodies 110 are coupled to channel regions 120 (indicated by dashed lines and not in the visible y-z plane of view 501).

Channel regions 120 can be seen in the gate-cut, x-z planes of views 502, 503. Conformal dielectric layer 144 is over bodies 110, on sidewall spacers 121, 122 of trench 115, and on and over an upper surface of substrate 199. In the embodiment of FIG. 5A, dummy gate 524 is over channel regions 120, and mask material 521 is over dummy gate 524. Sacrificial material 520 is between channel regions 120, which have not been released.

Returning to FIG. 4, methods 400 continue with depositing a dielectric material over the substrate at operation 420. In many embodiments, the dielectric material is devoid of oxygen and nitrogen. In many embodiments, the dielectric material is pure silicon. In many embodiments, the dielectric material is amorphous silicon. In many embodiments, the dielectric material is deposited between the sidewalls of a trench over the substrate, over and between the source or drain bodies in the trench. The dielectric material may be much as dielectric 141 is described at FIG. 1A and elsewhere. The dielectric material may be deposited by any suitable means, for example, a sputter, low-pressure CVD (LPCVD) of amorphous silicon, etc. The deployment of amorphous silicon as the dielectric material may enable a relatively low-temperature deposition (which may conserve thermal budget) and low-cost deposition. In many embodiments, a bulk, low-K dielectric material (e.g., of pure silicon) is deposited over a dielectric layer conformally deposited over the source and drain bodies. In some such embodiments, when depositing the bulk dielectric material over and between the source and drain bodies, the bulk dielectric material is deposited over and within the conformally deposited dielectric liner layer. The dielectric material may be deposited to any suitable height, e.g., below a top of the trench and sidewalls. In some embodiments, the dielectric material is deposited to a first height (e.g., at or over a top of the trench and sidewalls) before being recessed down to a second height below the first height (e.g., below a top of the trench and sidewalls).

FIG. 5B shows dielectric material 141 on conformal dielectric layer 144 over source and drain material bodies 110 in (and over) trench 115 in a workpiece or device 100, in accordance with some embodiments, for example, following a performance of depositing operation 420. View 501 illustrates dielectric material 141 over conformal dielectric layer 144, which is conformally over bodies 110 (e.g., on sidewalls 111 of bodies 110) and spacers 121, 122 at a bottom of trench 115. Views 502, 503 show dielectric material 141 over conformal dielectric layer 144 in trench 115 and over a top of trench 115 and sidewalls of trench 115.

Returning to FIG. 4, methods 400 continue at operation 430 with optionally recessing the dielectric material to below an uppermost surface of the sacrificial gate structure. In some embodiments, the dielectric material is deposited to a height over a top of the trench and sidewalls. In some such embodiments, the dielectric material is recessed down to a lower height (e.g., below a top of the trench and sidewalls). The dielectric material may be recessed to any suitable height. In some embodiments, a subsequently deposited layer will mask the dielectric material during a removal of a dummy (e.g., polysilicon) gate structure. In some such embodiments, the dielectric material is recessed enough to allow for a sufficient thickness of the deposited mask layer to provide protection during the dummy gate removal. The dielectric material may be recessed by any suitable means, including conventional etches of silicon, such as those used for removing polysilicon dummy gates. An etch of the dielectric material may be selective to, e.g., the conformal dielectric liner layer.

FIG. 5C illustrates dielectric material 141 on conformal dielectric layer 144 over source and drain material bodies 110 within trench 115 in a workpiece or device 100, in accordance with some embodiments, for example, following a performance of recessing operation 430. View 501 shows dielectric material 141 at a lower height, e.g., within trench 115. Views 502, 503 illustrate dielectric material 141 at a lower height within trench 115, e.g., below a top of dummy gate 524.

Returning to FIG. 4, methods 400 continue with depositing a mask layer over the dielectric material at operation 440. The mask layer may be another dielectric, a second dielectric that has portions retained, e.g., in the trench, between source and drain bodies. The mask layer may be deposited to any suitable depth, for example, to provide an etch selectivity over the (e.g., first) dielectric material over source and drain bodies and with a material of the sacrificial (dummy) gate material. The mask layer (e.g., second dielectric) may be deposited to a height within the trench. In some embodiments, the mask layer is deposited to a height over the trench, e.g., before being recessed down to within the trench. In many embodiments, the mask layer is deposited to a height over the trench before being recessed down by a planarization, for example, a chemical-mechanical planarization or polish (CMP). In some embodiments, the mask layer is deposited to certain height, but is subsequently reduced in height when being subjected to (and shielding the first dielectric from) an etch. The mask layer may be any suitable material (for example, much as second dielectric 142 is described at FIG. 1A and elsewhere), e.g., having an etch selectivity with the (first) dielectric material and dummy gate. The mask layer may be deposited by any suitable means, for example, by CVD, ALD, etc. In many embodiments, the mask layer includes oxygen. In some such embodiments, the mask layer includes aluminum (e.g., in an oxide of aluminum, AlₓO_{y}, such as Al₂O₃). The mask layer may be of or include any suitable material(s).

FIG. 5D shows first and second dielectrics 141, 142 over source and drain material bodies 110 in trench 115 in a workpiece or device 100, in accordance with some embodiments, for example, following a performance of depositing operation 440. View 501 illustrates second, masking dielectric 142 over first dielectric 141 in trench 115. Views 502, 503 show masking dielectric 142 over dielectric 141 in trench 115 and up to and over a top of trench 115 and sidewalls of (layer 144 and) trench 115. First and second dielectrics 141, 142 are over conformal dielectric layer 144, on sidewalls of layer 144. First and second dielectrics 141, 142 are over conformal dielectric layer 144, which is on sidewall spacers 121, 122 of trench 115.

Returning to FIG. 4, methods 400 continue at operation 450 with optionally planarizing the substrate. In many embodiments, the substrate is planarized. The substrate may be planarized by any suitable means, such as a CMP. In some embodiments, the substrate is planarized, and the planarizing removes the conformal layer over the sacrificial gate structure. The conformal layer may otherwise protect the sacrificial gate structure (e.g., as an etch-stop layer), and removing the conformal layer may allow for the removal of the sacrificial gate structure. In some embodiments, the substrate is planarized, and the planarizing reveals the sacrificial gate structure between the first and second source or drain bodies. For example, the planarizing may remove a hardmask (or other mask material) over the dummy or sacrificial gate structure. In some embodiments, the substrate is planarized, and the planarizing recesses the mask layer to a level with the sacrificial gate structure. The planarizing may recess multiple materials, such as conformal layers on sidewalls, to a same height.

FIG. 5E illustrates dummy gate 524 revealed and at a same level as (e.g., planarized with) masking dielectric 142 in a workpiece or device 100, in accordance with some embodiments, for example, following a performance of planarizing operation 450. View 501 shows masking dielectric 142 with a reduced (but sufficient) height over first dielectric 141, e.g., within trench 115. Masking dielectric 142 may have a sufficient height or thickness over first dielectric 141 to protect dielectric 141, for example, during a removal of dummy gate 524. Views 502, 503 illustrate dielectric 142 with a reduced height over first dielectric 141 in trench 115, between conformal layer 144 and level with revealed dummy gate 524. Sacrificial or dummy gate 524 is exposed, prepared for removal.

Returning to FIG. 4, methods 400 continue with replacing the sacrificial gate structure with a gate electrode at operation 460. The sacrificial gate structure may have served a masking function over channel regions, e.g., nanoribbons, as well as a sacrificial function, occupying the space (e.g., as a placeholder) eventually filled by a gate electrode. In many embodiments, the sacrificial gate structure includes silicon. For example, in many embodiments, the sacrificial gate structure is polysilicon. In many embodiments, the sacrificial gate structure is removed with an etch selective to the mask layer. For example, the sacrificial gate structure may be removed by an isotropic etch of polysilicon that retains the mask layer (e.g., of an oxide or nitride). In many embodiments with nanoribbon channel regions, after the sacrificial gate structure is removed, an isotropic etch removes sacrificial material between the nanoribbons, revealing the nanoribbons.

FIG. 5F shows masking dielectric 142 over first dielectric 141 and source and drain bodies 110 in trenches 115, and channel regions 120 exposed between bodies 110 and trenches 115, in a workpiece or device 100, in accordance with some embodiments, for example, during a performance of replacing operation 460. View 501 illustrates dielectric 142 still masking over first dielectric 141 and bodies 110 in trench 115. Views 502, 503 show dummy gates absent adjacent bodies 110, trenches 115, and channel regions 120. Channel regions 120 are exposed or revealed between bodies 110 in trenches 115.

FIG. 5G illustrates masking dielectric 142 over first dielectric 141 and source and drain bodies 110 in trenches 115, and gate structures 320 between bodies 110 and over channel regions 120, in a workpiece or device 100, in accordance with some embodiments, for example, following a performance of replacing operation 460. View 501 shows masking dielectric 142 maintained in trenches 115 over first dielectric 141 and source and drain bodies 110. Views 502, 503 illustrate gate dielectric 323 on and around channel regions 120 and on bulk portion 325 of gate electrode 324. Gate contacts 226 are on bulk portions 325 of electrode 324 and have upper surfaces at a same level as (e.g., planarized with) masking dielectric 142.

Returning to FIG. 4, methods 400 continue at operation 470 with removing the mask layer over the source or drain bodies. An etch selectivity may be used to remove the mask layer generally, and one or more additional masks may be used to remove certain, select portions and retain others. For example, the mask (or second dielectric) layer may be selectively removed at certain locations, such as over source or drain bodies, using other (e.g., lithographic) masks to form contacts where desired for certain source or drain bodies. In some embodiments, the (second dielectric) mask layer is in the trench, and a photolithographic mask (and other layers) extending beyond the trench is used over the mask layer to selectively remove portions of the mask layer in the trench. The mask (or second dielectric) layer may be patterned using any suitable means. In many embodiments, the mask layer is patterned using photolithographic masks and one or more mask layers (e.g., at least one layer of photoresist), for example, a hard mask layer (e.g., including carbon), a bottom anti-reflective coating (BARC), etc. The mask layer may be patterned to have openings of any suitable size and location. In many embodiments, the mask layer is patterned to have openings over source and drain bodies, e.g., to expose the source and drain bodies, either with openings particular to each body or with larger openings shared by multiple bodies to be coupled by a metallization structure. In many embodiments, one or more portions of the mask layer are removed over first and second source or drain bodies, and another portion of the mask layer is retained, e.g., in the trench over a portion of retained dielectric material.

FIG. 5H shows masking dielectric 142 with retained portions between openings 543 (and portions removed at openings 543 over source or drain bodies 110 in a workpiece or device 100, in accordance with some embodiments, for example, following a performance of removing operation 470. Dielectrics 141, 142 are in trenches 115, e.g., extending in both the positive and negative y-directions. Dielectric 143 is over dielectrics 141, 142, extending in both the positive and negative x- and y-directions, over and beyond sidewalls of trench 115. View 501 illustrates selectively removed and retained portions of masking, second dielectric 142. Openings 543 in masking dielectrics 142, 142 leave first dielectric 141 exposed over source or drain bodies 110. Masking dielectric 142 is over first dielectric 141 in trench 115, but absent over first dielectric 141 at openings 543 over source or drain bodies 110 in trench 115. Third or masking dielectric 143 is over trench 115 and on and over second or masking dielectric 142 between openings 543. gate structures 320 between trenches 115. Views 502, 503 show third or masking dielectric 143 over and on a surface collectively made up of spacers 121, 122, dielectrics 142 (not shown), layers 144, and gate contacts 226. Openings 543 in masking dielectrics 142, 142 leave first dielectric 141 exposed over source or drain bodies 110. Third, masking dielectric 143 is between openings 543 over source or drain bodies 110. Mask dielectric 143 is present over gate structures 320. In some embodiments, mask dielectric 143 has openings 543 over gate contacts 226. In some such embodiments, openings 543 in mask dielectric 143 over gate contacts 226 are in front or behind the visible x-z plane, e.g., in the positive or negative y-direction.

Returning to FIG. 4, methods 400 continue with removing the dielectric material at operation 480, for example, to expose the source and drain bodies. The composition of the dielectric material (e.g., of pure, amorphous silicon) enables a very selective etch (for example, with hot ammonia) to remove all of the dielectric material and provide a wide contact area on the source and drain bodies at the bottom of the trench. In many embodiments, the dielectric material is removed over at least the first and second source or drain bodies. In many embodiments, the dielectric material is removed over at least the first and second source or drain bodies, and a portion of the dielectric material is retained in the trench, between the first and second source or drain bodies. Selected portions of the dielectric material may be removed over the first and second source or drain bodies, exposing the first and second source or drain bodies, by an etch selective to one or more masking layers over the dielectric material. The etch may be advantageously selective to the masking layer(s), removing the dielectric material and retaining the oxide(s) and/or nitride(s) of the masking layer(s), due to the composition of the dielectric material, e.g., pure, amorphous silicon.

The masking layer enables an anisotropic etch (e.g., a biased or directed etch) of the dielectric material, which allows selected (e.g., masked) portions of the dielectric material to be retained (for example, between source and drain bodies). The source and drain bodies may be exposed by any suitable etch, e.g., an etch selective to the mask layer. The removed first dielectric material may be that dielectric material not covered by the masking layer(s), e.g., under or in the openings in the mask layer. In some such embodiments, the openings in the mask layer(s) are over multiple source and drain bodies and the area between the multiple bodies. In at least some such embodiments, sufficient first dielectric material is removed over and between the multiple bodies to form a metallization structure (e.g., a contact) over, between, and coupling the multiple bodies. In embodiments having a conformally deposited dielectric layer on and over the source and drain bodies, the conformally deposited dielectric layer on and over the source and drain bodies may be substantially retained when the first dielectric material not covered by the mask layer is removed, e.g., under or in the openings in the mask layer. In some such embodiments, the conformally deposited dielectric layer is then removed by a separate anisotropic etch (e.g., at operation 490, forming contact structures), and a thinned portion of the conformally deposited dielectric layer is retained on sidewalls of the trench (e.g., on spacer layers adjacent gate structures). If desired, further (e.g., isotropic) etches may remove thinned sidewall portions of the formerly conformal dielectric layer. In some embodiments, the etching and exposing of the source and drain bodies removes some (e.g., slight) portions of the exposed source and drain bodies.

FIG. 5I illustrates exposed source and drain bodies 110 in a workpiece or device 100, in accordance with some embodiments, for example, following a performance of removing operation 480. View 501 shows exposed source and drain bodies 110 with larger openings 543 in and through dielectrics 142, 143 and into dielectric 141. Views 502, 503 illustrate exposed source and drain bodies 110 in openings 543 in and through dielectric 143. Conformal layer 144 is substantially removed over bodies 110. Bodies 110 are exposed and available for contacting. In some embodiments, some of layers 144 remain (e.g., thinned) on sidewall spacers 122.

Returning to FIG. 4, methods 400 continue at operation 490 with forming first and second metallization structures in contact with the first and second source or drain bodies. Forming the metallization structures may be by any suitable means and with any suitable materials, for example, those described of metallization structure 130 at FIG. 1A. In many embodiments, the metallization structure includes one or more metal layers deposited over the exposed source and drain bodies. In some such embodiments, at least one liner (e.g., conformal) layer is first deposited over one or more source or drain bodies, and a fill layer is deposited over the liner layer(s). In many embodiments, the metallization structure is coupled to the source or drain body or bodies at an interface layer (e.g., of metallized semiconductor body). A deposited liner layer may alloy or otherwise bond or interface with an upper surface of the source or drain body, for example, a highly conductive contact or interface layer of, on, or over the semiconductor body, e.g., a silicide layer. In some embodiments, the forming the metallization structures in contact with the source or drain bodies forms the contact metallization structures with the retained portion of the dielectric material between the metallization structures, e.g., conformal to the dielectric material. In some embodiments, forming metallization structures in contact with the source or drain bodies forms the metallization structures with the retained portion of the dielectric material and the retained portion of the mask layer between the contact structures, e.g., conformal to the dielectric material and masking layer. In some embodiments (as previewed at operation 480), the forming the metallization structures in contact with the source or drain bodies includes removing the conformal layer over the source or drain bodies.

FIG. 5J shows IC device 100 and transistor structures 101 having source or drain bodies 110 coupled with enhanced structures 130, in accordance with some embodiments, for example, following a performance of forming operation 490. View 501 illustrates dielectric stacks 140 between source or drain bodies 110 and metallization structures 130. Bodies 110 are between stacks 140, and structures 130 are between stacks 140. Views 502, 503 show wide metallization structures 130 on and coupled with source or drain bodies 110, e.g., at layers 132 and exposed bodies 110 (e.g., not coved by layers 144). Metallization structures 130 span the entire width of trenches 115.

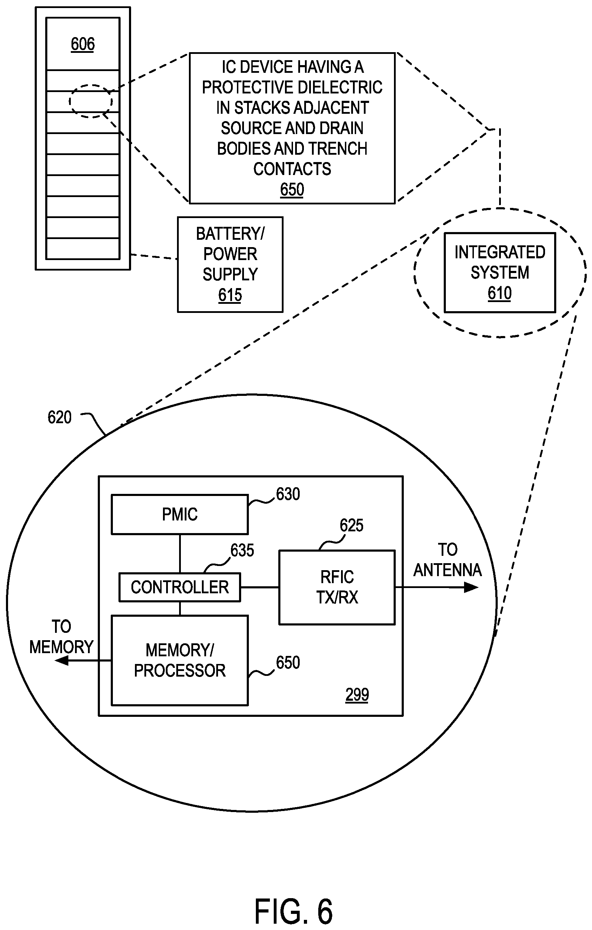

FIG. 6 illustrates a diagram of an example data server machine 606 employing an IC device having enhanced contacts on source and drain bodies, in accordance with some embodiments, e.g., having a maximized width across the trench and formed by a selective etch of amorphous silicon. Server machine 606 may be any commercial server, for example, including any number of high-performance computing platforms disposed within a rack and networked together for electronic data processing, which in the exemplary embodiment includes one or more devices 650 having enhanced contacts on source and drain bodies.

Also as shown, server machine 606 includes a battery and/or power supply 615 to provide power to devices 650, and to provide, in some embodiments, power delivery functions such as power regulation. Devices 650 may be deployed as part of a package-level integrated system 610. Integrated system 610 is further illustrated in the expanded view 620. In the exemplary embodiment, devices 650 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 650 is a microprocessor including a static RAM (SRAM) cache memory. As shown, device 650 may be an IC device having enhanced contacts on source and drain bodies, as discussed herein. Device 650 may be further coupled to (e.g., communicatively coupled to) a board, an interposer, or a substrate 199 along with, one or more of a power management IC (PMIC) 630, RF (wireless) IC (RFIC) 625 including a wideband RF (wireless) transmitter and/or receiver (TX/RX) (e.g., including a digital baseband and an analog front end module further includes a power amplifier on a transmit path and a low noise amplifier on a receive path), and a controller 635 thereof. In some embodiments, RFIC 625, PMIC 630, controller 635, and device 650 include having enhanced contacts on source and drain bodies.

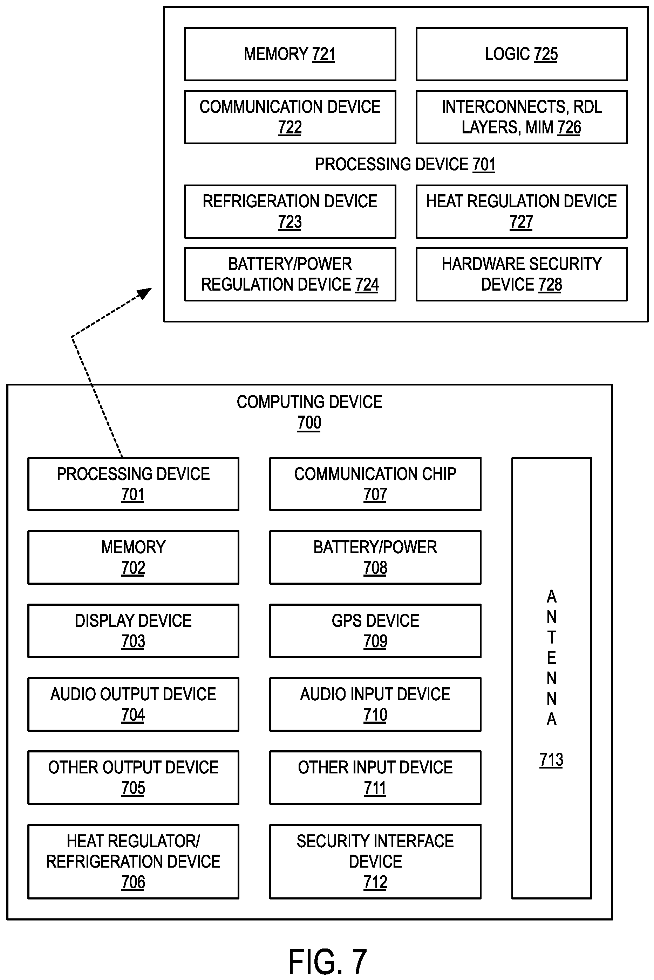

FIG. 7 is a block diagram of an example computing device 700, in accordance with some embodiments. For example, one or more components of computing device 700 may include any of the devices or structures discussed herein. A number of components are illustrated in FIG. 7 as being included in computing device 700, but any one or more of these components may be omitted or duplicated, as suitable for the application. In some embodiments, some or all of the components included in computing device 700 may be attached to one or more printed circuit boards (e.g., a motherboard). In some embodiments, various ones of these components may be fabricated onto a single system-on-a-chip (SoC) die. Additionally, in various embodiments, computing device 700 may not include one or more of the components illustrated in FIG. 7, but computing device 700 may include interface circuitry for coupling to the one or more components. For example, computing device 700 may not include a display device 703, but may include display device interface circuitry (e.g., a connector and driver circuitry) to which display device 703 may be coupled. In another set of examples, computing device 700 may not include an audio output device 704, other output device 705, global positioning system (GPS) device 709, audio input device 710, or other input device 711, but may include audio output device interface circuitry, other output device interface circuitry, GPS device interface circuitry, audio input device interface circuitry, audio input device interface circuitry, to which audio output device 704, other output device 705, GPS device 709, audio input device 710, or other input device 711 may be coupled.

Computing device 700 may include a processing device 701 (e.g., one or more processing devices). As used herein, the term "processing device" or "processor" indicates a device that processes electronic data from registers and/or memory to transform that electronic data into other electronic data that may be stored in registers and/or memory. Processing device 701 may include a memory 721, a communication device 722, a refrigeration device 723, a battery/power regulation device 724, logic 725, interconnects 726 (i.e., optionally including redistribution layers (RDL) or metal-insulator-metal (MIM) devices), a heat regulation device 727, and a hardware security device 728.

Processing device 701 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 700 may include a memory 702, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 702 includes memory that shares a die with processing device 701. This memory may be used as cache memory and may include embedded dynamic random-access memory (eDRAM) or spin transfer torque magnetic random-access memory (STT-MRAM).

Computing device 700 may include a heat regulation/refrigeration device 706. Heat regulation/refrigeration device 706 may maintain processing device 701 (and/or other components of computing device 700) at a predetermined low temperature during operation.

In some embodiments, computing device 700 may include a communication chip 707 (e.g., one or more communication chips). For example, the communication chip 707 may be configured for managing wireless communications for the transfer of data to and from computing device 700. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 707 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 707 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 707 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 707 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 707 may operate in accordance with other wireless protocols in other embodiments. Computing device 700 may include an antenna 713 to facilitate wireless communications and/or to receive other wireless communications (such as AM or FM radio transmissions).

In some embodiments, communication chip 707 may manage wired communications, such as electrical, optical, or any other suitable communication protocols (e.g., the Ethernet). As noted above, communication chip 707 may include multiple communication chips. For instance, a first communication chip 707 may be dedicated to shorter-range wireless communications such as Wi-Fi or Bluetooth, and a second communication chip 707 may be dedicated to longer-range wireless communications such as GPS, EDGE, GPRS, CDMA, WiMAX, LTE, EV-DO, or others. In some embodiments, a first communication chip 707 may be dedicated to wireless communications, and a second communication chip 707 may be dedicated to wired communications.

Computing device 700 may include battery/power circuitry 708. Battery/power circuitry 708 may include one or more energy storage devices (e.g., batteries or capacitors) and/or circuitry for coupling components of computing device 700 to an energy source separate from computing device 700 (e.g., AC line power).

Computing device 700 may include a display device 703 (or corresponding interface circuitry, as discussed above). Display device 703 may include any visual indicators, such as a heads-up display, a computer monitor, a projector, a touchscreen display, a liquid crystal display (LCD), a light-emitting diode display, or a flat panel display, for example.

Computing device 700 may include an audio output device 704 (or corresponding interface circuitry, as discussed above). Audio output device 704 may include any device that generates an audible indicator, such as speakers, headsets, or earbuds, for example.

Computing device 700 may include an audio input device 710 (or corresponding interface circuitry, as discussed above). Audio input device 710 may include any device that generates a signal representative of a sound, such as microphones, microphone arrays, or digital instruments (e.g., instruments having a musical instrument digital interface (MIDI) output).

Computing device 700 may include a GPS device 709 (or corresponding interface circuitry, as discussed above). GPS device 709 may be in communication with a satellite-based system and may receive a location of computing device 700, as known in the art.

Computing device 700 may include other output device 705 (or corresponding interface circuitry, as discussed above). Examples of the other output device 705 may include an audio codec, a video codec, a printer, a wired or wireless transmitter for providing information to other devices, or an additional storage device.

Computing device 700 may include other input device 711 (or corresponding interface circuitry, as discussed above). Examples of the other input device 711 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 700 may include a security interface device 712. Security interface device 712 may include any device that provides security measures for computing device 700 such as intrusion detection, biometric validation, security encode or decode, access list management, malware detection, or spyware detection.

Computing device 700, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1A-7. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes first and second source or drain bodies over a substrate, the first source or drain body in a first transistor structure and the second source or drain body in a second transistor structure, a first structure comprising a metal on the first source or drain body, a second structure comprising the metal on the second source or drain body, and a dielectric is over the substrate, the dielectric between the first and second source or drain bodies and between the first and second structures comprising the metal, the dielectric consisting of substantially pure silicon.

In one or more second embodiments, further to the first embodiments, the dielectric is a first dielectric, a second dielectric is on a first sidewall of the first source or drain body, the second dielectric is on a second sidewall of the second source or drain body, and the first dielectric is between the second dielectric on the first and second sidewalls.

In one or more third embodiments, further to the first or second embodiments, a conformal layer including the second dielectric is on the first and second sidewalls, and the conformal layer is under the first dielectric between the first and second sidewalls.

In one or more fourth embodiments, further to the first through third embodiments, also including a third source or drain body in a third transistor structure, wherein the first structure comprising the metal is over and between the first and third source or drain bodies.

In one or more fifth embodiments, further to the first through fourth embodiments, an intervening portion of the first structure comprising the metal is between the first and third source or drain bodies, and a second dielectric is between the intervening portion and the first source or drain body and between the intervening portion and the third source or drain body.

In one or more sixth embodiments, further to the first through fifth embodiments, the dielectric is a first dielectric, a third dielectric is between the first and second structures comprising the metal, and the third dielectric is over the first dielectric in a stack.

In one or more seventh embodiments, further to the first through sixth embodiments, a fourth dielectric is between the first and second structures comprising the metal, the fourth dielectric is over the first dielectric in the stack, the fourth dielectric is between the first and third dielectrics.

In one or more eighth embodiments, further to the first through seventh embodiments, the stack is a first stack, the third dielectric is over the first dielectric in second and third stacks, the first structure comprising the metal is between the first and second stacks, and the second structure comprising the metal is between the first and third stacks.

In one or more ninth embodiments, further to the first through eighth embodiments, also including a third structure comprising the metal on a third source or drain body in a third transistor structure, wherein the second stack is between the first and third source or drain bodies and between the first and third structures comprising the metal, and a fourth structure comprising the metal on a fourth source or drain body in a fourth transistor structure, wherein the third stack is between the second and fourth source or drain bodies and between the second and fourth structures comprising the metal.

In one or more tenth embodiments, further to the first through ninth embodiments, the first dielectric is in a trench extending in a first direction between the first and second source or drain bodies, the third dielectric is over the trench, and the third dielectric extends beyond the trench in a second direction perpendicular to the first direction.

In one or more eleventh embodiments, an apparatus includes first and second source or drain bodies over a substrate, the first source or drain body in a first transistor structure and the second source or drain body in a second transistor structure, a first structure comprising a metal on the first source or drain body, a second structure comprising the metal on the second source or drain body, and a dielectric between the first and second source or drain bodies and between the first and second structures comprising the metal, wherein the dielectric includes silicon, and the dielectric is devoid of oxygen and nitrogen.

In one or more twelfth embodiments, further to the eleventh embodiments, the dielectric is a first dielectric, a first layer of a second dielectric is on the first source or drain body, a second layer of the second dielectric is on the second source or drain body, and the first dielectric is on and between the first and second layers.

In one or more thirteenth embodiments, further to the eleventh or twelfth embodiments, The first and second source or drain bodies are in a trench over the substrate, the trench extends in a first direction between the first and second source or drain bodies, the first dielectric is in the trench a third dielectric is over the first dielectric, and the third dielectric extends beyond the trench in a second direction perpendicular to the first direction.

In one or more fourteenth embodiments, a method includes depositing a dielectric material over and between first and second source or drain bodies over a substrate, the dielectric material consisting of substantially pure silicon, depositing a mask layer over the dielectric material, removing the mask layer over at least the first and second source or drain bodies, removing the dielectric material over at least the first and second source or drain bodies, and forming first and second metallization structures in contact with the first and second source or drain bodies.

In one or more fifteenth embodiments, further to the fourteenth embodiments, the removing the dielectric material over at least the first and second source or drain bodies retains a portion of the dielectric material in a trench between the first and second source or drain bodies.

In one or more sixteenth embodiments, further to the fourteenth or fifteenth embodiments, the forming the first and second metallization structures in contact with the first and second source or drain bodies forms the first and second metallization structures with the retained portion of the dielectric material between the first and second metallization structures.

In one or more seventeenth embodiments, further to the fourteenth through sixteenth embodiments, the removing the mask layer over at least the first and second source or drain bodies retains a portion of the mask layer in the trench over the portion of the dielectric material, and the forming the first and second metallization structures in contact with the first and second source or drain bodies forms the first and second metallization structures with the retained portion of the dielectric material and the retained portion of the mask layer between the first and second metallization structures.

In one or more eighteenth embodiments, further to the fourteenth through seventeenth embodiments, also including depositing a conformal layer over the substrate, the conformal layer over the first and second source or drain bodies, wherein the forming the first and second metallization structures in contact with the first and second source or drain bodies includes removing the conformal layer over the first and second source or drain bodies.

In one or more nineteenth embodiments, further to the fourteenth through eighteenth embodiments, also including planarizing the substrate, wherein the depositing the conformal layer over the substrate deposits the conformal layer over a sacrificial gate structure between the first and second source or drain bodies, and the planarizing the substrate removes the conformal layer over the sacrificial gate structure, recesses the mask layer to a level with the sacrificial gate structure, and reveals the sacrificial gate structure between the first and second source or drain bodies.

In one or more twentieth embodiments, further to the fourteenth through nineteenth embodiments, also including replacing the sacrificial gate structure with a gate electrode, wherein the sacrificial gate structure includes silicon, and the replacing the sacrificial gate structure removes the sacrificial gate structure with an etch selective to the mask layer.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
first and second source or drain bodies over a substrate, the first source or drain body in a first transistor structure and the second source or drain body in a second transistor structure;
a first structure comprising a metal on the first source or drain body;
a second structure comprising the metal on the second source or drain body; and
a dielectric is over the substrate, the dielectric between the first and second source or drain bodies and between the first and second structures comprising the metal, the dielectric consisting of substantially pure silicon.

2. The apparatus of claim 1, wherein:
the dielectric is a first dielectric;
a second dielectric is on a first sidewall of the first source or drain body;
the second dielectric is on a second sidewall of the second source or drain body; and
the first dielectric is between the second dielectric on the first and second sidewalls.

3. The apparatus of claim 2, wherein a conformal layer comprising the second dielectric is on the first and second sidewalls, and the conformal layer is under the first dielectric between the first and second sidewalls.

4. The apparatus of any one of claims 1-3, further comprising a third source or drain body in a third transistor structure, wherein the first structure comprising the metal is over and between the first and third source or drain bodies.

5. The apparatus of claim 4, wherein:
an intervening portion of the first structure comprising the metal is between the first and third source or drain bodies; and
a second dielectric is between the intervening portion and the first source or drain body and between the intervening portion and the third source or drain body.

6. The apparatus of any one of claims 1-5, wherein the dielectric is a first dielectric, a third dielectric is between the first and second structures comprising the metal, and the third dielectric is over the first dielectric in a stack.

7. The apparatus of claim 6, wherein a fourth dielectric is between the first and second structures comprising the metal, the fourth dielectric is over the first dielectric in the stack, the fourth dielectric is between the first and third dielectrics.

8. The apparatus of claim 6 or 7, wherein:
the stack is a first stack;
the third dielectric is over the first dielectric in second and third stacks;
the first structure comprising the metal is between the first and second stacks; and
the second structure comprising the metal is between the first and third stacks.

9. The apparatus of claim 8, further comprising:
a third structure comprising the metal on a third source or drain body in a third transistor structure, wherein the second stack is between the first and third source or drain bodies and between the first and third structures comprising the metal; and
a fourth structure comprising the metal on a fourth source or drain body in a fourth transistor structure, wherein the third stack is between the second and fourth source or drain bodies and between the second and fourth structures comprising the metal.

10. The apparatus of one of the claims 6-9, wherein:
the first dielectric is in a trench extending in a first direction between the first and second source or drain bodies;
the third dielectric is over the trench; and
the third dielectric extends beyond the trench in a second direction perpendicular to the first direction.

11. A method, comprising:
depositing a dielectric material over and between first and second source or drain bodies over a substrate, the dielectric material consisting of substantially pure silicon;
depositing a mask layer over the dielectric material;
removing the mask layer over at least the first and second source or drain bodies;
removing the dielectric material over at least the first and second source or drain bodies; and
forming first and second metallization structures in contact with the first and second source or drain bodies.

12. The method of claim 11, wherein the removing the dielectric material over at least the first and second source or drain bodies retains a portion of the dielectric material in a trench between the first and second source or drain bodies.

13. The method of claim 12, wherein the forming the first and second metallization structures in contact with the first and second source or drain bodies forms the first and second metallization structures with the retained portion of the dielectric material between the first and second metallization structures.

14. The method of claim 12 or 13, wherein the removing the mask layer over at least the first and second source or drain bodies retains a portion of the mask layer in the trench over the portion of the dielectric material, and the forming the first and second metallization structures in contact with the first and second source or drain bodies forms the first and second metallization structures with the retained portion of the dielectric material and the retained portion of the mask layer between the first and second metallization structures.

15. The method of any one of claims 11-14, further comprising depositing a conformal layer over the substrate, the conformal layer over the first and second source or drain bodies, wherein the forming the first and second metallization structures in contact with the first and second source or drain bodies comprises removing the conformal layer over the first and second source or drain bodies.
